# EUROPÄISCHE PATENTSCHRIFT

(11) **EP 4 133 913 B1**
(45) Veröffentlichungstag und Bekanntmachung des Hinweises auf die Patenterteilung: **04.09.2024**
(21) Anmeldenummer: 21715864.1
(22) Anmeldetag: 25.03.2021
(51) Int. Cl.: H05K 5/00, H05K 5/06, H05K 5/03, H05K 9/00

(54) **GEHÄUSE MIT INTEGRIERTEN SCHUTZABSCHNITT UMFASSENDEN GEHÄUSETEIL**
HOUSING WITH A HOUSING PART COMPRISING AN INTEGRATED PROTECTIVE SECTION
BOÎTIER AVEC UNE PARTIE DE BOÎTIER COMPRENANT UNE SECTION DE PROTECTION INTÉGRÉE

(30) Priorität: 08.04.2020 DE 102020109898
(43) Veröffentlichungstag der Anmeldung: 15.02.2023
(73) Patentinhaber: ElringKlinger AG, 72581 Dettingen (DE)
(72) Erfinder: ULMER, Benjamin, 72574 Bad Urach (DE); SCHÖLLHAMMER, Jochen, 72581 Dettingen (DE); KUNERT, Tobias, 72764 Reutlingen (DE); GOLCHERT, Bodo, 72649 Wolfschlugen (DE); EBERLE, Bernhard, 72555 Metzingen (DE); BETZ, Björn, 72818 Trochtelfingen (DE)
(74) Vertreter: Pfiz/Gauss Patentanwälte PartmbB
(86) Internationale Anmeldenummer: PCT/EP2021/057831
(87) Internationale Veröffentlichungsnummer: WO 2021/204558

(56) Entgegenhaltungen:
- DE-A1- 19 755 765
- DE-C1- 4 405 408
- DE-C5- 19 755 765

## Beschreibung

Die Erfindung betrifft ein Gehäuse insbesondere für eine elektrotechnische Vorrichtung, wobei das Gehäuse zumindest zwei Gehäuseteile umfasst und die mindestens zwei Gehäuseteile jeweils eine Verbindungsfläche aufweisen, wobei in einem geschlossenen Zustand des Gehäuses die Verbindungsflächen entlang eines Verbindungsabschnitts einander zugewandt sind.

Außerdem betrifft die Erfindung eine elektrotechnische Vorrichtung und ein Kraftfahrzeugbauteil und ein Kraftfahrzeug, jeweils insbesondere umfassend ein Gehäuse der voranstehend genannten Art.

Insbesondere ist ein Innenraum des Gehäuses, welcher zumindest von den mindestens zwei Gehäuseteilen zumindest teilweise umgeben wird, als Aufnahme für elektrische Bauteile der elektrotechnischen Vorrichtung ausgebildet. Insbesondere sind in einem zusammengebauten Zustand elektrische Bauteile der elektrotechnischen Vorrichtung in dem Innenraum angeordnet. Beispielsweise ist zumindest ein elektrisches Bauteil eine Autobatterie und/oder eine elektrische Steuerungseinrichtung.

Die DE 44 05 408 C1 offenbart ein Metallgehäuse für den Einbau elektronischer Bauteile, im Wesentlichen bestehend aus einem Gehäuseunterteil und einem Deckel, wobei der Deckel einen eine umlaufende Nut mit innenliegender Dichtung begrenzenden Innenrand und Außenrand besitzt, und bei geschlossenem Deckel eine am Gehäuseunterteil vorgesehene, umlaufende Feder in die Nut eingreifend gegen die Dichtung gepresst ist, wobei die Stirnfläche des Innenrandes bei geschlossenem Deckel leitend auf dem Gehäuseunterteil aufliegt, während der Außenrand und das Gehäuseunterteil unter Bildung eines Spaltes kontaktfrei bleiben.

In der DE 197 55 765 A1 wird ein Gehäuse mit einem Deckel für eine elektronische Baugruppe, insbesondere eine elektronische Kraftfahrzeug-Baugruppe, wobei die elektronische Baugruppe im Gehäuse mit einer Vergussmasse vergossen wird, vorgeschlagen, wobei beim Verschließen des Gehäuses mit dem Deckel das Gehäuse und der Deckel Vorrichtungen zur Bildung eines gemeinsamen Formschlusses aufweisen und die Seitenwände des Deckels zumindest teilweise in die Vergussmasse eintauchen.

Die der Erfindung zugrunde liegende Aufgabe besteht darin, ein Gehäuse und/oder eine elektrotechnische Vorrichtung und/oder ein Kraftfahrzeugbauteil und/oder ein Kraftfahrzeug zu verbessern, insbesondere deren Funktionalität zu verbessern und/oder deren Betriebssicherheit zu erhöhen.

Erfindungsgemäß wird die voranstehend genannte Aufgabe durch ein Gehäuse gemäß dem Anspruch 1 und eine elektrotechnische Vorrichtung gemäß dem Anspruch 14 und ein Kraftfahrzeugbauteil und/oder Kraftfahrzeug gemäß Anspruch 15 gelöst.

Beispielsweise dient zumindest ein integrierter Schutzabschnitt für einen mechanischen Schutz, insbesondere gegen Fluide, vorzugsweise gegen Wasser und/oder Reinigungsflüssigkeiten, insbesondere aus einem Hochdruckreiniger, und/oder gegen kleine feste Partikel, insbesondere Staub-, Abrieb- und/oder Schmutzteilchen.

Insbesondere ist zumindest ein integrierter Schutzabschnitt für eine EMV-Abschirmung ausgebildet. Vorzugsweise vermindert dieser integrierte Schutzabschnitt eine Ausbreitung von elektromagnetischen Wellen aus dem Innenraum des Gehäuses nach außen und/oder von außen in den Innenraum hinein und insbesondere wird durch den Schutzabschnitt solch eine Ausbreitung zumindest näherungsweise verhindert. Dabei ist insbesondere die Ausbildung für den EMV-Schutz alternativ oder ergänzend zu der Ausbildung als mechanischer Schutz bei zumindest einem Schutzabschnitt möglich.

Insbesondere ist somit einer der Vorteile der erfindungsgemäßen Lösung darin zu sehen, dass der Innenraum des Gehäuses durch den integrierten Schutzabschnitt, insbesondere vor äußeren Fremdeinwirkungen, beispielsweise durch äußere materielle feste und/oder flüssige Verschmutzungen und/oder elektromagnetische Einwirkungen besser geschützt ist und insbesondere darin angeordnete elektrische Bauteile ebenso geschützt sind.

Vorzugsweise werden auch von in dem Innenraum des Gehäuses angeordneten elektrischen Bauteilen ausgehende Störeinflüsse auf die Umgebung des Gehäuses, beispielsweise auf weitere Teile der elektronischen Vorrichtung oder des Kraftfahrzeugs, durch zumindest einen insbesondere als EMV-Abschirmungsabschnitt ausgebildeten Schutzabschnitt zumindest verringert oder gar zumindest näherungsweise verhindert.

Insbesondere ist der für eine EMV-Abschirmung ausgebildete Schutzabschnitt eine Ausbreitung von elektromagnetischen Wellen beeinträchtigend ausgebildet und erhöht somit die elektromagnetische Verträglichkeit (EMV) des Gehäuses mit insbesondere darin angeordneten elektrischen Bauteilen. Vorzugsweise ist dabei der Schutzabschnitt derart ausgestaltet, dass er zumindest eine, insbesondere mehrere, beispielsweise sämtliche Anforderungen von entsprechenden Normen und/oder gesetzlichen Regelungen zur elektromagnetischen Verträglichkeit erfüllt.

Beispielsweise ist ein Vorteil der erfindungsgemäßen Lösung darin zu sehen, dass zumindest eines der Gehäuseteile zumindest einen integrierten Schutzabschnitt aufweist, wobei insbesondere durch die Integration des Schutzabschnitts an das Gehäuseteil eine Montage desselben vereinfacht wird und somit beispielsweise das Gehäuse kostengünstiger hergestellt werden kann.

Bei einigen vorteilhaften Ausführungsformen ist vorgesehen, dass entlang des Verbindungsabschnitts genau ein Schutzabschnitt vorgesehen ist. Beispielsweise ist hierdurch das entsprechende Gehäuseteil einfach und somit kostengünstig herstellbar.

Bei anderen besonders günstigen Ausführungsformen ist vorgesehen, dass entlang des Verbindungsabschnitts genau zwei Schutzabschnitte vorgesehen sind, wodurch beispielsweise jeweils einer dieser Schutzabschnitte für eine jeweilige Anforderung, insbesondere zum Einen für einen mechanischen Schutz und zum anderen für eine EMV-Abschirmung, entsprechend spezialisiert ausgebildet werden kann und somit vorzugsweise eine Schutzwirkung erhöht werden kann.

Bei einigen vorteilhaften Ausführungsformen mit mehreren Schutzabschnitten entlang des Verbindungsabschnitts weisen beide der zumindest zwei Gehäuseteile jeweils mindestens einen integrierten Schutzabschnitt auf.

Bei anderen besonders vorteilhaften Ausführungsformen ist vorgesehen, dass bei mehreren vorgesehenen Schutzabschnitten lediglich eines der zumindest zwei Gehäuseteilen die mehreren Schutzabschnitte aufweist, wodurch insbesondere die Herstellung des anderen der zwei Gehäuseteile einfacher und somit kostengünstiger ist.

Hinsichtlich der Ausbildung des zumindest einen Schutzabschnitts und/oder der mehreren Schutzabschnitte wurden bislang keine näheren Angaben gemacht.

Insbesondere weist ein oder der genau eine Schutzabschnitt und/oder weisen mehrere, beispielsweise sämtliche der mehreren, insbesondere der genau zwei, Schutzabschnitte eines oder mehrerer der nachstehend erläuterten Merkmale auf. Somit ist nachstehend bei der Erläuterung eines Merkmals im Zusammenhang mit zumindest einem Schutzabschnitt diese Formulierung derart zu verstehen, dass der genau eine Schutzabschnitt und/oder einer, vorzugsweise mehrere, beispielsweise sämtliche, der mehreren, insbesondere der genau zwei, Schutzabschnitte dieses erläuterte Merkmal aufweisen.

Besonders günstig ist es, wenn zumindest ein Schutzabschnitt verliersicher an einem der Gehäuseteile angeordnet ist. Insbesondere ist dadurch der zumindest eine Schutzabschnitt mit dem einen Gehäuseteil fest verbunden und an dieses integriert und vorzugsweise wird dadurch die Montage vereinfacht und fehlerunanfälliger, da weniger einzelne zu montierende Bauteile vorgesehen sind.

Bei besonders vorteilhaften Ausführungsformen ist vorgesehen, dass ein Abschnitt des einen Gehäuseteils zumindest einen Schutzabschnitt ausbildet. Insbesondere ist somit kein separates Bauteil für den zumindest einen Schutzabschnitt erforderlich, so dass insbesondere Herstellungskosten verringert und vorzugsweise die Montage des Gehäuses vereinfacht werden können.

Besonders günstig ist es, wenn zumindest ein Schutzabschnitt ein umgeformter Abschnitt des einen Gehäuseteils ist, wodurch eine einfache Herstellung und Ausbildung desselben ermöglicht wird.

Beispielsweise ist zumindest ein Schutzabschnitt, insbesondere der zumindest eine umgeformte Schutzabschnitt, in das eine Gehäuseteil eingepresst oder eingeprägt.

Bei einigen bevorzugten Ausführungsformen ist vorgesehen, dass zumindest ein Schutzabschnitt ein an das eine Gehäuseteil angeformter Abschnitt ist.

Dabei ist der angeformte Abschnitt beispielsweise aus einem anderen Werkstoff als das Gehäuseteil ausgebildet. Bei anderen vorteilhaften Ausführungsformen ist vorgesehen, dass der angeformte Abschnitt aus dem gleichen Werkstoff wie das eine Gehäuseteil ausgebildet ist.

Insbesondere ist es bei dem angeformten Abschnitt möglich, diesen an spezielle Anforderungen entsprechend auszubilden und vorzugsweise fest mit dem einen Gehäuseteil zu verbinden, so dass insbesondere durch den angeformten Abschnitt ein flexibel ausbildbarer und gut mit dem Gehäuseteil verbindbarer integrierter Schutzabschnitt in günstiger Weise hergestellt werden kann.

Bei besonders vorteilhaften Ausführungsformen ist vorgesehen, dass ein einem Gehäuseteil zugeordnetes Schutzelement zumindest einen Schutzabschnitt ausbildet. Insbesondere können, wenn das Schutzelement ein von dem Gehäuseteil unterschiedliches vorgefertigtes Element ist, diese beiden entsprechend ihren Anforderungen konstruiert und gefertigt werden und insbesondere kann durch eine, beispielsweise wie nachstehend erläuterte, Integration derselben vor der Montage des Gehäuses das eine Gehäuseteil mit einem integrierten Schutzabschnitt versehen werden und diese Montage einfach und weniger fehleranfällig erfolgen.

Insbesondere ist das Schutzelement an das zugeordnete Gehäuseteil, insbesondere bereits vor der Montage, fixiert.

Besonders vorteilhaft ist es, wenn das Schutzelement mit dem zugeordneten Gehäuseteil stoff-, form- und/oder kraftschlüssig verbunden ist.

Insbesondere ist das Schutzelement mit einem Halteabschnitt, insbesondere entlang des Verbindungsabschnitts zumindest teilweise, vorzugsweise durchgängig, an dem zugeordneten Gehäuseteil, insbesondere verliersicher, angeordnet.

Insbesondere ist das Schutzelement, insbesondere ein Halteabschnitt desselben, mittels Durchsetzfügen mit dem einen Gehäuseteil verbunden.

Bei besonders vorteilhaften Ausführungsformen ist vorgesehen, dass das Schutzelement durch Stoffschluss, beispielsweise durch Schweißen, mit dem einen Gehäuseteil verbunden ist.

Dabei ist bei unterschiedlichen Ausführungsformen das Schutzelement aus unterschiedlichen Werkstoffen hergestellt.

Bei besonders günstigen Ausführungsformen ist vorgesehen, dass das Schutzelement aus einem metallischen Werkstoff ausgebildet ist. Beispielsweise ist dieses dadurch günstig und stabil herstellbar. Durch die Leitfähigkeit des metallischen Werkstoffs wird vorzugsweise die EMV-Abschirmung erhöht.

Beispielsweise umfasst der metallische Werkstoff Stahl, insbesondere Kohlenstoffstahl oder Federstahl.

Bei einigen günstigen Ausführungsformen umfasst der metallische Werkstoff Aluminium und/oder Kupfer und/oder Beryllium.

Beispielsweise ist der metallische Werkstoff eine Legierung, insbesondere umfassend Kupfer und/oder Beryllium und/oder Aluminium.

Vorzugsweise ist das Schutzelement beschichtet, beispielsweise mit einer insbesondere Nickel- und/oder kupferumfassenden Metallbeschichtung.

Bei einigen vorteilhaften Ausführungsformen ist das Schutzelement aus insbesondere nickel- oder kupferplatiertem Stahl, beispielsweise Federstahl oder Kaltband.

Vorzugsweise ist das Schutzelement aus einem Flachmaterial hergestellt. Besonders günstig ist es, wenn das Schutzelement eine metallische Lage ist, beispielsweise aus einem Blech. Vorzugsweise ist das Schutzelement als ein eine Gehäuseteilöffnung des gegenüberliegend angeordneten Gehäuseteils umfangseitig geschlossen umrandender Ring ausgebildet.

Beispielsweise ist eine derartige Ausgestaltung günstig herstellbar und lässt sich bauraumsparend integrieren, so dass dadurch ein Schutzabschnitt mit guter Schutzfunktion kostengünstig und auch bei höchstens kleinem freien Bauraum realisierbar ist.

Besonders günstig ist es, wenn zumindest ein Schutzabschnitt ein umgeformter Abschnitt des Schutzelements, insbesondere der beispielsweise metallischen Lage, ist. Insbesondere lässt sich hierdurch ein konstruktiv einfacher und kostengünstig herstellbarer Schutzabschnitt realisieren.

Besonders günstig ist es, wenn zumindest ein Schutzabschnitt flächig ausgebildet ist.

Insbesondere weist zumindest ein flächiger Schutzabschnitt eine Kontaktierungsfläche auf, mit welcher das gegenüberliegend angeordnete Gehäuseteil zumindest in dem geschlossenen Zustand kontaktiert wird. Insbesondere wird mittels der Kontaktierungsfläche eine gute vorzugsweise vollflächige Kontaktierung mit dem gegenüberliegenden Gehäuseteil ermöglicht, wodurch insbesondere eine EMV-Abschirmung verbessert wird.

Es ist jedoch wesentlich, wenn zumindest ein Schutzabschnitt flächig zur Abdeckung eines Spalts zwischen den Verbindungsflächen in dem geschlossenen Zustand des Gehäuses ausgebildet ist, wodurch der Spalt entlang des Schutzabschnitts abgedeckt ist und ein mechanischer Schutz vor äußeren Einflüssen verbessert wird.

Bei einigen günstigen Ausführungsformen ist vorgesehen, dass zumindest ein Schutzabschnitt eine Kante aufweist. Insbesondere hat die Kante quer zu einer Längserstreckung des Schutzabschnitts einen dornartigen Querschnitt, wobei die Längserstreckung insbesondere entlang der Verbindungskontur gerichtet ist. Günstigerweise steht die Kante über eine Verbindungsseite des diesen Schutzabschnitt aufweisenden Gehäuseteils hervor. Besonders vorteilhaft ist es, wenn die Kante sich auf das gegenüberliegende Gehäuseteil insbesondere bis zu einer Kantenspitze zu erstreckend ausgebildet ist, insbesondere ausgehend von dem Gehäuseteil oder von dem Schutzelement ausgehend. Vorzugsweise kontaktiert die Kante, beispielsweise mit ihrer Kantenspitze, das gegenüberliegende Gehäuseteil und wird insbesondere auf dieses aufgepresst. Hierdurch wird beispielsweise eine gute Kontaktierung zwischen den Gehäuseteilen oder dem gegenüberliegenden Gehäuseteil und dem Schutzelement ermöglicht. Bei einigen Ausführungsformen wird mittels der Kante beispielsweise auch eine feste Verbindung zwischen den Gehäuseteilen realisiert.

Bei einigen vorteilhaften Ausführungsformen ist zumindest ein Schutzabschnitt durch eine Sicke ausgebildet. Beispielsweise ist die Sicke eine Halbsicke oder eine Vollsicke. Dabei bildet die Ausbildung der Sicken eine breite Variationsmöglichkeit, wodurch der Schutzabschnitt in konstruktiv einfacher Weise speziellen Anforderungen entsprechend günstig ausbildbar ist.

Bei einigen günstigen Ausführungsformen weist die Sicke entlang des Verbindungsabschnitts im Wesentlichen eine gleiche Form und/oder die gleichen Abmessungen auf.

Bei einigen besonders vorteilhaften Ausführungsformen variiert die Form und/oder die Abmessungen der Sicke entlang des Verbindungsabschnitts. Beispielsweise variiert die Höhe der Sicke entlang des Verbindungsabschnitts, wobei vorzugsweise an Befestigungsstellen und/oder Stellen, an welchen eine Beaufschlagung erfolgt, die Höhe kleiner ist als zwischen diesen Stellen, wodurch insbesondere eine Kontaktierung an das gegenüberliegende Gehäuseteil gleichmäßiger und verbessert wird. Insbesondere wird die Sickenhöhe als Abstand zwischen einander abgewendeter Seiten eines Sickendaches und eines Sickenfußes bei einer Vollsicke und zwischen einander abgewendeter Seiten benachbarter Sickenfüße bei einer Halbsicke gemessen. Insbesondere ist die Sicke mit zwei Sickenfüßen an beabstandete Abschnitte angeordnet, wobei bei einer Vollsicke zwischen den zwei Sickenfüßen das abstehende Sickendach angeordnet ist und bei einer Halbsicke die zwei Sickenfüße quer zum Sickenverlauf versetzt und zueinander abstehend angeordnet sind.

Beispielsweise ist die den zumindest einen Schutzabschnitt ausbildende Sicke in einem der Gehäuseteile ausgebildet. Bei vorteilhaften Ausführungsformen ist die den zumindest einen Schutzabschnitt ausbildende Sicke in dem insbesondere als metallische Lage ausgebildeten Schutzelement vorgesehen.

Bei besonders günstigen Ausführungsformen ist zumindest ein Schutzabschnitt federnd gelagert ausgebildet. Insbesondere wird hierdurch eine Kontaktierung des gegenüberliegend angeordneten Gehäuseteils verbessert, da durch die federnd gelagerte Ausbildung Toleranzen des anderen Gehäuseteils ausgeglichen werden können.

Beispielsweise ist zumindest ein Schutzabschnitt federnd mit dem Rest des diesen Schutzabschnitt ausbildenden Gehäuseteils oder Schutzelements verbunden.

Vorzugsweise ist der zumindest eine federnd verbundene Schutzabschnitt mit einem die Verbindungsfläche ausbildenden Abschnitt des diesen Schutzabschnitts ausbildenden Gehäuseteils federnd verbunden. Alternativ oder ergänzend ist beispielsweise vorgesehen, dass dieser Schutzabschnitt mit einem Deckelabschnitt, welcher eine Gehäuseteilöffnung des gegenüberliegend angeordneten Gehäuseteils im geschlossenen Zustand bedeckt, federnd verbunden ist.

Wenn der federnd verbundene Schutzabschnitt von dem Schutzelement ausgebildet wird, ist es besonders günstig, wenn dieser Schutzabschnitt mit dem Halteabschnitt des Schutzelements federnd verbunden ist.

Hinsichtlich der weiteren Anordnung des zumindest einen Schutzabschnitts, insbesondere hinsichtlich der Anordnung bezüglich dem gegenüberliegenden Gehäuseteil wurden bislang keine näheren Angaben gemacht.

Besonders günstig ist es, wenn zumindest ein Schutzabschnitt in dem geschlossenen Zustand des Gehäuses das gegenüberliegend angeordnete der mindestens zwei Gehäuseteile entlang des Verbindungsabschnitts zumindest teilweise, vorzugsweise zumindest näherungsweise durchgängig kontaktiert. Dies ist insbesondere für die EMV-Abschirmung günstig, da hierdurch eine zumindest teilweise durchgängige Verbindung zwischen den Gehäuseteilen hergestellt wird und dadurch vorzugsweise die Ausbreitung der elektromagnetischen Wellen zumindest vermindert wird. Auch für einen mechanischen Schutz kann das zumindest teilweise kontaktieren günstig sein, da hierdurch der Spalt beispielsweise an diesen Stellen zumindest im Wesentlichen geschlossen ist und somit insbesondere Verschmutzungen nicht in diesen hineintreten können.

Insbesondere stellt zumindest ein Schutzabschnitt zumindest abschnittsweise, beispielsweise durchgängig, entlang des Verbindungsabschnitts einen metallischen und/oder galvanischen Kontakt zwischen den mindestens zwei Gehäuseteilen her.

Günstig ist es, wenn zumindest ein Schutzabschnitt die mindestens zwei Gehäuseteile entlang des Verbindungsabschnitts zumindest abschnittsweise, beispielsweise durchgängig, elektrisch leitend verbindet.

Bei besonders vorteilhaften Ausführungsformen ist vorgesehen, dass zumindest ein Schutzabschnitt in dem geschlossenen Zustand des Gehäuses an der Verbindungsfläche des gegenüberliegend angeordneten Gehäuseteils zumindest teilweise anliegt. Insbesondere bietet dies eine konstruktiv einfache Lösung und die Montage wird vereinfacht, da die Verbindungsfläche bereits dem Gehäuseteil mit dem Schutzabschnitt zugewandt ist. Insbesondere ist die Verbindungsfläche eine nachbearbeitete und somit geringe Toleranzen aufweisende Fläche, so dass die Kontaktierung verbessert wird.

Bei einigen vorteilhaften Ausführungsformen ist vorgesehen, dass zumindest ein Schutzabschnitt in dem geschlossenen Zustand des Gehäuses zumindest teilweise an einer von der Verbindungsfläche sich hinweg erstreckenden Wandabschnittsfläche des gegenüberliegend angeordneten Gehäuseteils anliegt. Beispielsweise ist dies günstig bei Gehäuseteilen mit dünnen Umwandungen, bei welchen an der Verbindungsfläche wenig Bauraum zur Verfügung steht, so dass dieser geringe Bauraum insbesondere für ein Dichtelement und/oder einen weiteren Schutzabschnitt genutzt werden kann. Auch ist insbesondere ein Anliegen an der Wandabschnittsfläche günstig, so dass der Spalt durchgängig abgedeckt und somit besonders günstig vor äußeren Einflüssen geschützt ist.

Bei einigen vorteilhaften Ausführungsformen ist vorgesehen, dass zumindest ein Schutzabschnitt entlang des Verbindungsabschnitts zumindest teilweise von dem gegenüberliegend angeordneten Gehäuseteil beabstandet ist. Dies ist insbesondere günstig für einen außenseitigen Schutzabschnitt, bei welchem zwischen diesem und einem in dem Spalt zwischen den Verbindungsflächen angeordneten Dichtelementen noch ein freier Raum vorhanden ist, in welchem sich Verschmutzungen und/oder Feuchtigkeit sammeln kann, welche durch den durch die Beabstandung zur Verfügung stehenden Freiraum aus dem Spalt wieder entweichen können.

Insbesondere ist es dabei günstig, wenn der von dem gegenüberliegend angeordneten Gehäuseteil beabstandete Schutzabschnitt von einer äußeren Wandabschnittsfläche desselben beabstandet ist und insbesondere einen Endbereich aufweist, welcher von außen betrachtet zumindest teilweise vor der Wandabschnittsfläche aber beabstandet von dieser angeordnet ist. Beispielsweise ist dabei der Schutzabschnitt als den Spalt abdeckender Kragen ausgebildet. Insbesondere erstreckt sich dieser Schutzabschnitt ausgehend von diesem Wandbereich in Richtung bis zu dem anderen Gehäuseteil, an welches dieser insbesondere wie voranstehend erläutert integriert ist, so dass vorzugsweise dieser Schutzabschnitt außenseitig den Spalt zwischen den Verbindungsflächen insbesondere für einen mechanischen Schutz überdeckt und teilweise überlappend aber insbesondere beabstandet zu der Wandabschnittsfläche angeordnet ist.

Bei einigen vorteilhaften Ausführungsformen ist die Ausbildung, insbesondere eine Form und/oder Abmessungen, zumindest eines Schutzabschnitts entlang des Verbindungsabschnitts im Wesentlichen gleich. Insbesondere bietet dies eine konstruktiv einfache und kostengünstige Lösung.

Bei einigen bevorzugten Ausführungsformen variiert die Ausbildung, beispielsweise eine Form und/oder Abmessungen, zumindest eines Schutzabschnitts entlang des Verbindungsabschnitts, so dass vorzugsweise die Schutzwirkung desselben optimiert werden kann. Beispielsweise variiert eine quer zu den Verbindungsflächen gemessenen Höhe des Schutzabschnitts. Insbesondere ist diese zwischen Stellen, an welchen eine Beaufschlagung erfolgt, größer als an diesen Beaufschlagungsstellen. Vorzugsweise wird hierdurch eine durchgängige Kontaktierung verbessert.

Bei bevorzugten Ausführungen ist zumindest ein Schutzabschnitt sich durchgängig entlang des Verbindungsabschnitts erstreckend ausgebildet. Beispielsweise kann hierdurch eine gute und durchgängige Schutzwirkung erzielt werden.

Bei einigen besonders vorteilhaften Ausführungsformen ist vorgesehen, dass zumindest ein Schutzabschnitt entlang des Verbindungsabschnitts eine oder mehrere Aussparungen aufweist. Dies ist insbesondere günstig, damit Verschmutzungen und/oder Feuchtigkeit hinter dem Schutzabschnitt, beispielsweise zwischen diesem und einem Dichtelement, aus der Aussparung heraus nach draußen gelangen können. Daher ist es besonders günstig, die Aussparungen klein auszugestalten, um eine Unterbrechung des Schutzes klein zu halten, und groß genug auszugestalten, um das Entweichen von Feuchtigkeit und/oder Flüssigkeit zu ermöglichen, wobei insbesondere eine Kapillarwirkung an der Aussparung und/oder entlang des Schutzabschnitts vermieden werden sollte.

Insbesondere ist es bei einem außenseitig angeordneten Schutzabschnitt günstig, die Aussparungen vorzusehen.

Vorzugsweise ist eine oder sind mehrere Aussparungen verwinkelt ausgebildet, so dass insbesondere diese Aussparung nicht direkt quer zu der Längserstreckung des Schutzabschnitts verläuft und dadurch auch im Bereich der Aussparung im Wesentlichen keine Unterbrechung des Schutzes durch den Schutzabschnitt vorliegt.

Besonders vorteilhaft ist es, wenn der Schutzabschnitt im Bereich einer Aussparung zwei Teilabschnitte aufweist, welche quer zu der Verbindungskontur versetzt zueinander verlaufen und insbesondere jeweils zumindest näherungsweise parallel zu der Verbindungskontur verlaufen. Vorzugsweise verläuft dabei die Aussparung im Bereich des versetzten Verlaufs zwischen den zwei Teilabschnitten, so dass insbesondere in diesem Bereich die Aussparung in Richtung quer zu der Verbindungskontur von den zwei Teilabschnitten begrenzt wird. Insbesondere weisen die zwei Teilabschnitte jeweils im Bereich der Aussparung ein Ende auf, an welchem insbesondere auch der versetzte Verlauf der zwei Teilabschnitte endet. Besonders günstig ist dabei, dass die Aussparung verwinkelt von dem Ende eines der Teilabschnitte an einer bezogen auf die Verbindungskontur Querseite des Schutzabschnitts zumindest näherungsweise in Richtung der Verbindungskontur zwischen den beiden Teilabschnitten schließlich bis zu dem Ende des anderen Teilabschnitts an der gegenüberliegenden Querseite verläuft. Somit ist günstiger Weise bei einer solchen insbesondere verwinkelt ausgebildeten Aussparung ein Entweichen von Flüssigkeit und/oder Feuchtigkeit ermöglicht, wobei ein durchgehender Schutz durch den überlappenden Verlauf der Teilabschnitte, insbesondere ein Schutz für das inwärts angeordnete Dichtelement vor von außen direkt einwirkenden Schadeinflüssen wie beispielsweise auftreffende Reinigungsflüssigkeit aus einem Hochdruckreiniger, weiterhin gegeben ist.

Vorzugsweise ist eine Längserstreckung der einen oder der mehreren Aussparungen, insbesondere entlang der Verbindungskontur, höchstens 10 mm, insbesondere höchstens 5 mm, beispielsweise höchstens 2 mm lang und/oder mindestens 0,1 mm, beispielsweise mindestens 0,5 mm, insbesondere mindestens 1 mm, lang. Beispielsweise ist die Längserstreckung der Aussparungen wesentlich kleiner, beispielsweise um mindestens das fünffache, insbesondere um mindestens das zehnfache, kleiner als eine Längserstreckung eines sich an die Aussparung anschließenden Abschnitts des Schutzabschnitts. Beispielsweise können die Aussparungen in unregelmäßigen Abständen zueinander angeordnet sein und bei anderen vorteilhaften Ausführungsformen sind die Aussparungen in regelmäßigen Abständen zueinander angeordnet.

Insbesondere sind die Aussparungen für eine EMV-Abschirmung passend ausgebildet, beispielsweise ist deren Abstand gleich oder ein ganzzahliges Vielfaches einer Wellenlänge von einer abzuschirmenden elektromagnetischen Welle.

Besonders vorteilhaft ist es, wenn zumindest ein Schutzabschnitt innenseitig entlang des Verbindungsabschnitts angeordnet ist. Insbesondere ist der innenseitig angeordnete Schutzabschnitt zwischen einem in dem Spalt zwischen den Verbindungsflächen angeordneten Dichtelement und dem Innenraum angeordnet. Insbesondere wird dabei auch ein innenseitig vorhandener Bauraum günstig durch dem Schutzabschnitt ausgenutzt, wobei beispielsweise auch ein an die Verbindungsfläche angrenzender Bereich des insbesondere deckelartigen Gehäuseteils für die Ausbildung und/oder Anordnung des innenseitigen Schutzabschnitts, insbesondere für das Formen, beispielsweise das Einprägen, des Schutzabschnitts oder für das Verbinden desselben mittels des Halteabschnitts an dem Gehäuseteil, genutzt werden kann.

Insbesondere kontaktiert der innenseitig vorgesehene Schutzabschnitt zumindest teilweise das gegenüberliegend angeordnete Gehäuseteil.

Vorzugsweise ist der innenseitig angeordnete Verbindungsabschnitt an einen innenseitigen Randabschnitt der Umwandung, an welchem insbesondere die Verbindungsfläche und eine Wandabschnittsfläche der Umwandung eines der Gehäuseteile zusammentreffen, angeordnet, beispielsweise für eine die Integration bildende Verbindung oder für eine Kontaktierung des den Randabschnitt aufweisenden gegenüberliegend angeordneten Gehäuseteils.

Insbesondere kontaktiert der Schutzabschnitt einen Randabschnitt, insbesondere eine Kante desselben, der Umwandung des gegenüberliegend angeordneten Gehäuseteils.

Bei besonders bevorzugten Ausführungsformen ist vorgesehen, dass zumindest ein Schutzabschnitt außenseitig entlang des Verbindungsabschnitts angeordnet ist. Insbesondere ist dies günstig, so dass Verschmutzungen bereits außenseitig von einem Eindringen abgehalten werden und beispielsweise auch ein in dem Spalt angeordnetes Dichtelement geschützt wird. Insbesondere ist der außenseitig vorgesehene Schutzabschnitt außenseitig mit einem der Gehäuseteile zur Integration an dieses mit diesem verbunden. Insbesondere kontaktiert der außenseitig vorgesehene Schutzabschnitt das gegenüberliegend angeordnete Gehäuseteil außenseitig, beispielsweise an einem Randabschnitt und/oder an einer äußeren Wandabschnittsfläche. Bei einigen vorteilhaften Ausführungsformen ist der außenseitig angeordnete Schutzabschnitt zu dem gegenüberliegend angeordneten Gehäuseteil beabstandet.

Beispielsweise ist der außenseitig angeordnete Schutzabschnitt an einem außenseitigen Randabschnitt, an welchem insbesondere die Verbindungsfläche und eine äußere Wandabschnittsfläche des entsprechenden Gehäuseteils zusammentreffen, angeordnet, beispielsweise verbunden oder kontaktierend angeordnet.

Bei einigen vorteilhaften Ausführungsformen ist der außenseitig angeordnete Schutzabschnitt an einer außenseitigen Wandabschnittsfläche kontaktierend oder beabstandet angeordnet.

Erfindungsgemäß deckt zumindest teilweise entlang des Verbindungsabschnitts ein Schutzabschnitt den Spalt zwischen den mindestens zwei Gehäuseteilen.

Dies bietet insbesondere einen günstigen Schutz gegen Verschmutzungen und/oder für die EMV-Abschirmung, da der durch den Spalt freiliegende Bereich durch den Schutzabschnitt abgedeckt ist. Beispielsweise ist der Schutzabschnitt außenseitig abdeckend ausgebildet, wodurch insbesondere der Schmutz bereits außenseitig abgehalten wird. Bei einigen günstigen Ausführungsformen ist der Schutzabschnitt innenseitig abdeckend ausgebildet, beispielsweise für eine EMV-Abschirmung oder um innenseitig den Spalt und/oder Innenraum zu schützen.

Insbesondere deckt der Schutzabschnitt den Spalt quer zu seiner Höhenausdehnung, welche zwischen den begrenzenden Verbindungsflächen verläuft, ab. Insbesondere ist vorgesehen, dass der Schutzabschnitt zumindest zwischen den geometrischen Verbindungsebenen, in welchen die Verbindungsflächen verlaufen, sich erstreckt und vorzugsweise zumindest einseitig, vorzugsweise beidseitig, also eine oder beide dieser geometrischen Verbindungsebenen überragt.

Bei einigen besonders vorteilhaften Ausführungsformen ist vorgesehen, dass die zumindest zwei Gehäuseteile außenseitig bündig abschließen, insbesondere im Bereich des Verbindungsabschnitts. Insbesondere ist dies günstig, damit an dem Übergang der Gehäuseteile keine störenden Vorsprünge auftreten und/oder für eine bauraumsparende Ausbildung des Verbindungsabschnitts.

Beispielsweise ist dabei ein außenseitig angeordneter Schutzabschnitt vorgesehen, welcher bündig mit dem gegenüberliegend angeordneten Gehäuseteil abschließt. Insbesondere gehen dabei eine äußere Wandabschnittsfläche und eine äußere Fläche des Schutzabschnitts außenseitig bündig ineinander über. Insbesondere ist der außenseitige Schutzabschnitt an einem außenseitigen Randabschnitt insbesondere kontaktierend vorgesehen.

Besonders günstig ist es, wenn zumindest ein Schutzabschnitt beaufschlagt an dem gegenüberliegend angeordneten Gehäuseteil anliegt. Insbesondere liegt ein federnd gelagerter Schutzabschnitt beaufschlagt an. Insbesondere wird durch die Beaufschlagung eine besonders günstige Kontaktierung und ein die Toleranzen des gegenüberliegend angeordneten Gehäuseteils ausgleichendes Anliegen ermöglicht.

Bei einigen vorteilhaften Ausführungsformen ist vorgesehen, dass zumindest entlang des Verbindungsabschnitts zumindest ein Schutzabschnitt zumindest teilweise sich plastisch verformend an das gegenüberliegend angeordnete Gehäuseteil anpasst. Insbesondere wird hierdurch eine gute Kontaktierung und/oder Verbindung zwischen den Gehäuseteilen und somit eine gute Schutzwirkung erreicht.

Hinsichtlich weiterer Elemente wurden bislang keine näheren Angaben gemacht.

Besonders vorteilhat ist es, wenn zumindest in dem geschlossenen Zustand zwischen den beiden Verbindungsflächen der zumindest zwei Gehäuseteile ein Dichtelement angeordnet ist. Insbesondere wirkt das Dichtelement medienabdichtend, insbesondere also somit gegen flüssige und/oder gasförmige Fluide und beispielsweise auch gegen kleine Partikel. Insbesondere wird hierdurch der Innenraum durch das Dichtelement abdichtend verschlossen. Vorzugsweise verläuft das Dichtelement durchgängig entlang des Verbindungsabschnitts und insbesondere zumindest im Wesentlichen entlang der Verbindungskontur.

Insbesondere ist das Dichtelement ein von dem einen Schutzabschnitt oder den mehreren Schutzabschnitten separates Teil, so dass sie jeweils separat für ihre jeweilige Funktion ausgelegt werden können.

Das Dichtelement kann aus den unterschiedlichsten abdichtenden Werkstoffen ausgebildet sein.

Beispielsweise ist das Dichtelement ein metallisches Dichtelement.

Bei anderen vorteilhaften Ausführungen ist das Dichtelement aus einem Polymere umfassenden Werkstoff.

Bei besonders vorteilhaften Ausführungsformen ist vorgesehen, dass das Dichtelement zumindest teilweise aus Elastomer ausgebildet ist und vorzugsweise ein elastomeres Dichtelement ist. Beispielsweise ist das Dichtelement als insbesondere elastomere Dichtraupe zwischen den Verbindungsflächen angeordnet.

Beispielsweise wird bei einigen Ausführungsformen das Dichtelement bei der Montage zwischen die Verbindungsflächen angeordnet.

Bei besonders vorteilhaften Ausführungsformen ist vorgesehen, dass das Dichtelement an einem der Gehäuseteile, insbesondere an einem Gehäuseteil mit Schutzabschnitt, fest angeordnet ist, insbesondere bereits vor der Montage des Gehäuses fest angeordnet ist. Insbesondere erleichtert dies die Montage und bietet bereits eine gute abdichtende Wirkung zwischen dem Dichtelement und dem einen Gehäuseteil.

Insbesondere ist das Dichtelement stoff-, kraft- und/oder formschlüssig mit zumindest einem Gehäuseteil verbunden.

Beispielsweise ist das Dichtelement selbst aus einem klebend haftenden Werkstoff ausgebildet und wird so selbsthaftend mit dem einen Gehäuseteil fest verbunden. Bei anderen vorteilhaften Ausführungsformen wird das Dichtelement mittels eines klebenden Stoffes mit dem einen Gehäuseteil fest verbunden.

Besonders vorteilhaft ist es, wenn relativ zu dem Dichtelement innenseitig zumindest ein Schutzabschnitt, insbesondere für eine EMV-Abschirmung und/oder für einen mechanischen Schutz, angeordnet ist, wobei somit der innenseitige Schutzabschnitt zwischen dem Dichtelement und dem Innenraum angeordnet ist. Alternativ oder ergänzend ist es besonders bevorzugt, wenn relativ zu dem Dichtelement außenseitig zumindest ein Schutzabschnitt angeordnet ist, wobei insbesondere das Dichtelement zwischen dem außenseitigen Schutzabschnitt und dem Innenraum angeordnet ist.

Besonders bevorzugte Ausführungsformen umfassen einen außenseitigen Schutzabschnitt, beispielsweise als geprägter Rand oder als Kragen, insbesondere mit Aussparungen, wobei günstiger Weise der außenseitige Schutzabschnitt als mechanischer Schutz für das Dichtelement dient, und einen innenseitigen Schutzabschnitt für eine EMV-Abschirmung, welcher insbesondere zumindest näherungsweise durchgängig das gegenüberliegende Gehäuseteil kontaktiert, sowie ein Dichtelement, welches zwischen den beiden Schutzabschnitten angeordnet ist.

Besonders vorteilhaft ist es, bei Ausführungsformen mit einem Schutzelement, wenn der Halteabschnitt und das Dichtelement zusammen an einem der Gehäuseteile angeordnet sind, so dass das gleiche Gehäuseteil mit dem Halteabschnitt und dem Dichtelement verbunden ist. Beispielsweise wird so eine Konstruktion und Montage der Gehäuseteile vereinfacht, da lediglich eines der Gehäuseteile für die Verbindung mit dem Dichtelement und dem Schutzelement ausgelegt werden muss.

Hinsichtlich weiterer Ausbildungen des Gehäuses und seiner Gehäuseteile wurden bislang keine näheren Angaben gemacht.

Besonders günstig ist es, wenn die mindestens zwei Gehäuseteile aneinander gepresst sind. Beispielsweise wird hierdurch eine stabile Verbindung zwischen diesen ermöglicht und insbesondere wird durch die Pressung eine Beaufschlagung des Dichtelements erreicht und dessen Dichtwirkung vorzugsweise erhöht.

Insbesondere sind die mindestens zwei Gehäuseteile axial aneinander gepresst. Insbesondere erfolgt die axiale Verpressung zumindest näherungsweise senkrecht zu einer geometrischen Ebene, in welcher das eine der mindestens zwei Gehäuseteile, welches insbesondere deckelartig ausgebildet ist, sich im Wesentlichen erstreckt, wobei eine Ausdehnung desselben senkrecht zu der geometrischen Ebene insbesondere wesentlich kleiner, beispielsweise mindestens um ein fünffaches, vorzugsweise um mindestens ein zehnfaches, kleiner ist als dessen maximale Erstreckung in der geometrischen Ebene. Besonders vorteilhaft ist es, wenn die axiale Verpressung quer, insbesondere zumindest näherungsweise senkrecht, zu den Verbindungsflächen, insbesondere zu geometrischen Verbindungsebenen derselben, erfolgt. Insbesondere erstreckt sich zumindest eine Umwandung der mindestens zwei Gehäuseteile zumindest näherungsweise parallel zur axialen Verpressung von ihrer Verbindungsfläche hinweg. Vorteilhafterweise wird eine Montage des Gehäuses durch die axiale Verpressung vereinfacht, da insbesondere die Gehäuseteile lediglich im Wesentlichen aufeinander gesetzt und verpresst werden müssen.

Insbesondere ist vorgesehen, dass zumindest im Wesentlichen keine radiale Verpressung zwischen den mindestens zwei Gehäuseteilen vorgesehen ist. Insbesondere verläuft eine Richtung der radialen Verpressung zumindest näherungsweise senkrecht zu einer Richtung der axialen Verpressung. Insbesondere wird beziehungsweise würde bei einer radialen Verpressung eine von der Verbindungsfläche sich hinweg erstreckende Wandabschnittsfläche beaufschlagt. Das Absehen von einer solchen radialen Verpressung vereinfacht insbesondere die Montage und insbesondere werden Verzerrungen und/oder Faltenwürfe in den Gehäuseteilen vermieden.

Insbesondere sind Befestigungsmittel vorgesehen, welche an Befestigungsstellen die zwei Gehäuseteile miteinander verbinden. Insbesondere sind die Befestigungsstellen bezogen auf den Innenraum außenseitig der Verbindungskontur vorgesehen, so dass insbesondere an diesen eine Leckagemöglichkeit in den Innenraum zumindest vermindert oder gar ganz verhindert wird.

Beispielsweise sind an dem einen, insbesondere deckelartig ausgebildeten, Gehäuseteil Flanschvorsprünge an den Befestigungsstellen vorgesehen und beispielsweise an dem anderen der mindestens zwei Gehäuseteile ist dessen Umwandung zur Aufnahme der Befestigungsmittel verstärkt ausgebildet, beispielsweise dicker ausgebildet.

Besonders günstig ist es, wenn zumindest ein Schutzabschnitt, beispielsweise zumindest außenseitig, entlang der Befestigungsstellen verläuft, und so insbesondere auch die Befestigungsstellen einen entsprechenden Schutz erhalten.

Vorzugsweise werden die Gehäuseteile durch die Befestigungsmittel beaufschlagt.

Bei besonders günstigen Ausführungsformen sind im Bereich der Befestigungsmittel Verformungsbegrenzer angeordnet. Insbesondere begrenzen die Verformungsbegrenzer eine Beaufschlagung durch die Befestigungsmittel und/oder eine Verformung der Gehäuseteile durch die Beaufschlagung und sind hierfür entsprechend stabil ausgebildet.

Beispielsweise sind die Verformungsbegrenzer umgeformte Abschnitte eines der Gehäuseteile.

Besonders günstig ist es, wenn zumindest ein Schutzabschnitt in zumindest einen Verformungsbegrenzer übergeht. Beispielsweise bildet zumindest ein Schutzabschnitt im Bereich zumindest einer Befestigungsstelle den Verformungsbegrenzer, insbesondere mit einem oder mehreren der erläuterten Merkmale, aus.

Alternativ oder ergänzend wird die voranstehend genannte Aufgabe durch eine elektrotechnische Vorrichtung gelöst, welche ein Gehäuse der eingangs genannten Art mit mindestens einem, vorzugsweise mehreren der voranstehend erläuterten Merkmale aufweist, wobei die Vorteile dieser Merkmale sich auf die elektrotechnische Vorrichtung übertragen.

Insbesondere ist dabei vorgesehen, dass zumindest ein elektrisches Bauteil der elektrotechnischen Vorrichtung in dem Innenraum des Gehäuses angeordnet ist und insbesondere dieses und/oder eine Umgebung desselben durch den mindestens einen integrierten Schutzabschnitt wie voranstehend erläutert geschützt ist.

Ferner wird alternativ oder ergänzend die eingangs genannte Aufgabe durch ein Kraftfahrzeugbauteil gelöst, welches ein Gehäuse und/oder eine elektrotechnische Vorrichtung mit mindestens einem, vorzugsweise mehreren der voranstehend erläuterten Merkmalen aufweist, wobei die voranstehend beschriebenen Vorteile sich auf das Kraftfahrzeugbauteil übertragen. Insbesondere ist für ein in dem Innenraum des Gehäuses angeordnetes elektrisches Bauteil und die Umgebung des Gehäuses bei dem Kraftfahrzeugbauteil die elektromagnetische Verträglichkeit wichtig. Außerdem bedarf es bei dem Kraftfahrzeugbauteil insbesondere auch eines mechanischen Schutzes, um beispielsweise bei einem Betrieb eines Kraftfahrzeugs entstehende Schmutzpartikel und/oder auf das Kraftfahrzeug einwirkende Fluide, beispielsweise witterungsbedingte Flüssigkeiten und/oder bei der Reinigung, beispielsweise mittels eines Hochdruckreinigers, auftretende Reinigungsflüssigkeiten insbesondere aus dem Innenraum des Gehäuses, fernzuhalten.

Ferner wird alternativ oder ergänzend die eingangs genannte Aufgabe durch ein Kraftfahrzeug gelöst, welches ein Gehäuse und/oder eine elektrotechnische Vorrichtung und/oder ein Kraftfahrzeugbauteil mit mindestens einem, vorzugsweise mehreren, der voranstehend erläuterten Merkmale aufweist, wobei die voranstehend beschriebenen Vorteile sich auf das Kraftfahrzeug entsprechend übertragen.

Voranstehend und nachfolgend ist unter der Formulierung zumindest näherungsweise im Zusammenhang mit einer Angabe zu verstehen, dass technisch bedingte und/oder technisch nicht relevante Abweichungen von der Angabe mit umfasst sind, insbesondere dass Abweichungen von bis zu 20 %, insbesondere von bis zu 10 %, beispielsweise von bis zu 5 % mit umfasst sind. Bei Richtungsangaben sind insbesondere Abweichungen von bis zu 20°, insbesondere von bis zu 10°, beispielsweise bis zu 5° mit umfasst.

In der Zeichnung zeigen:
- Fig. 1: eine Draufsicht auf ein erstes Ausführungsbeispiel eines Gehäuses;
- Fig. 2: eine Explosionsdarstellung des Gehäuses des ersten Ausführungsbeispiels;
- Fig. 3: eine weitere Explosionsdarstellung des Gehäuses des ersten Ausführungsbeispiels;
- Fig. 4: eine Schnittdarstellung des Gehäuses des ersten Ausführungsbeispiels gemäß dem Schnitt IV-IV wie in Fig. 1 eingezeichnet;
- Fig. 5: eine ausschnittsweise vergrößerte Darstellung eines in Fig. 4 mit V bezeichneten Bereichs eines Verbindungsabschnitts zwischen zwei Gehäuseteilen des Gehäuses;
- Fig. 6: eine schematische Schnittdarstellung des Verbindungsabschnitts des ersten Ausführungsbeispiels;
- Fig. 7: eine schematische Schnittdarstellung eines Verbindungsabschnitts eines zweiten Ausführungsbeispiels;
- Fig. 8: eine schematische Schnittdarstellung eines Verbindungsabschnitts eines dritten Ausführungsbeispiels;
- Fig. 9: eine schematische Schnittdarstellung eines Verbindungsabschnitts eines vierten Ausführungsbeispiels;
- Fig. 10: eine schematische Schnittdarstellung eines Verbindungsabschnitts eines fünften Ausführungsbeispiels;
- Fig. 11: eine schematische Schnittdarstellung eines Verbindungsabschnitts eines sechsten Ausführungsbeispiels;
- Fig. 12: eine Schnittdarstellung eines Gehäuses eines siebten Ausführungsbeispiels;
- Fig. 13: eine ausschnittsweise vergrößerte Darstellung eines in Fig. 12 mit XIII bezeichneten Bereichs eines Verbindungsabschnitts mit einem Befestigungsmittel;
- Fig. 14: eine ausschnittsweise vergrößerte Darstellung eines in Fig. 12 mit XIV bezeichneten Bereichs des Verbindungsabschnitts;
- Fig. 15: eine perspektivische Darstellung auf ein insbesondere deckelartiges Gehäuseteil des siebten Ausführungsbeispiels und
- Fig. 16a): eine ausschnittsweise vergrößerte Darstellung einer Variante des und b) insbesondere deckelartigen Gehäuseteils gemäß Fig. 15 im Bereich überlappender Schutzabschnitte.

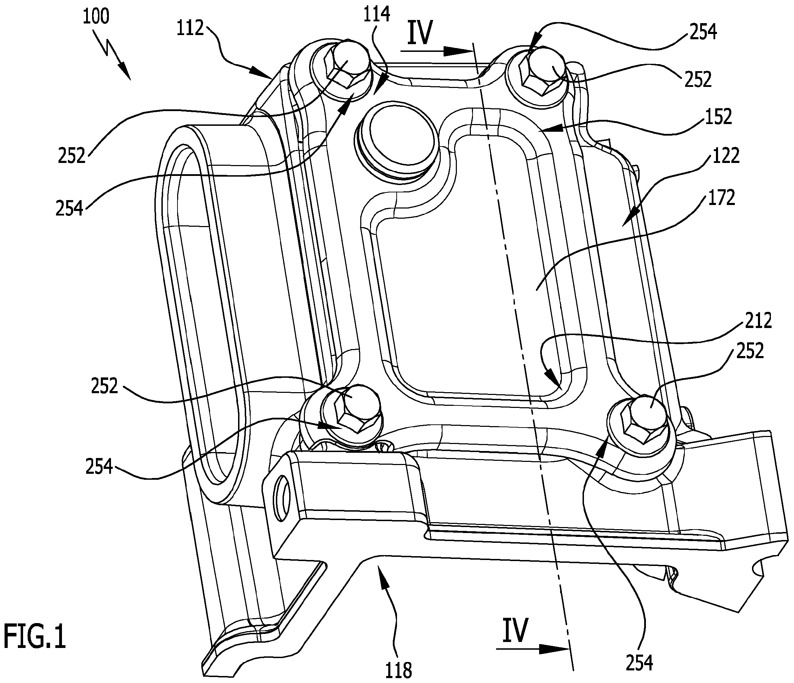

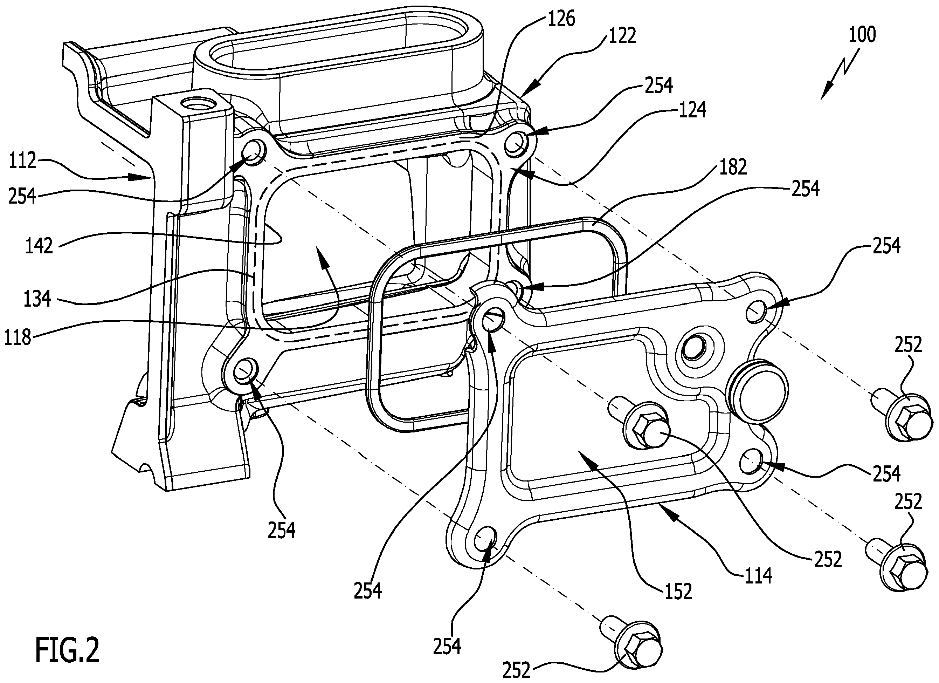

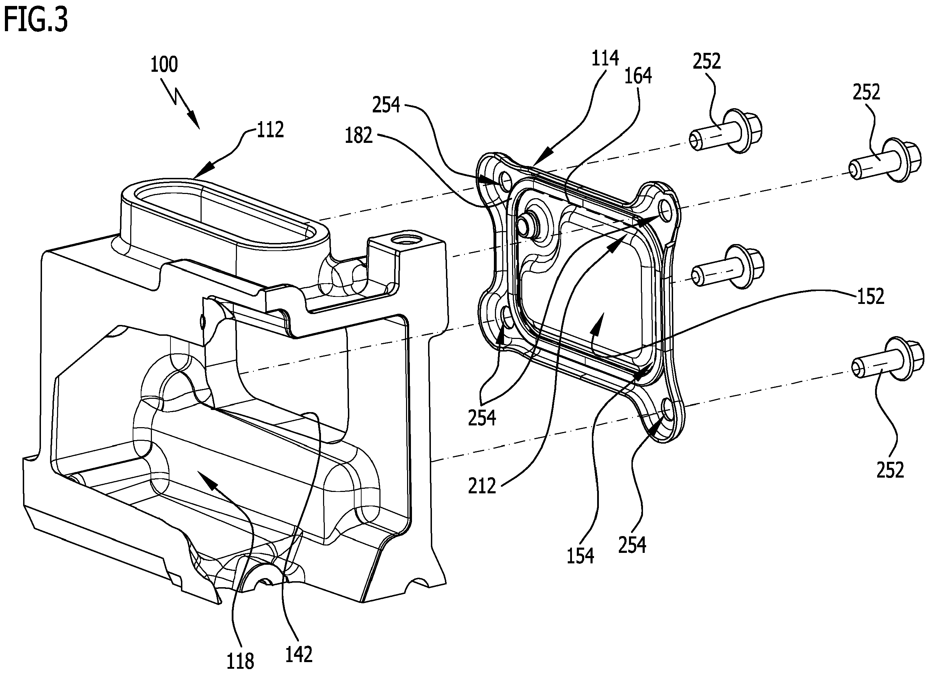

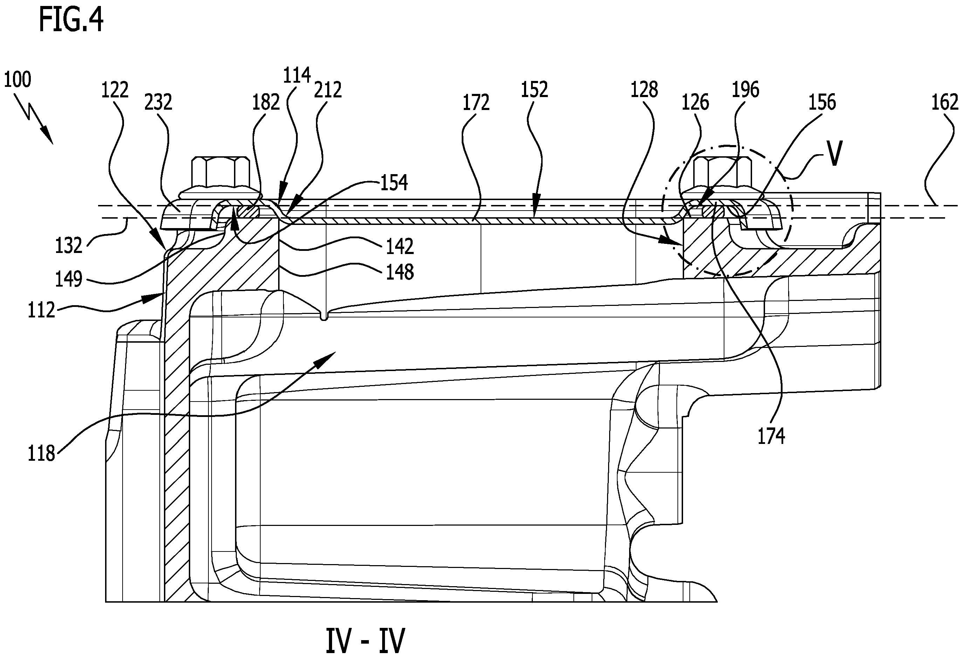

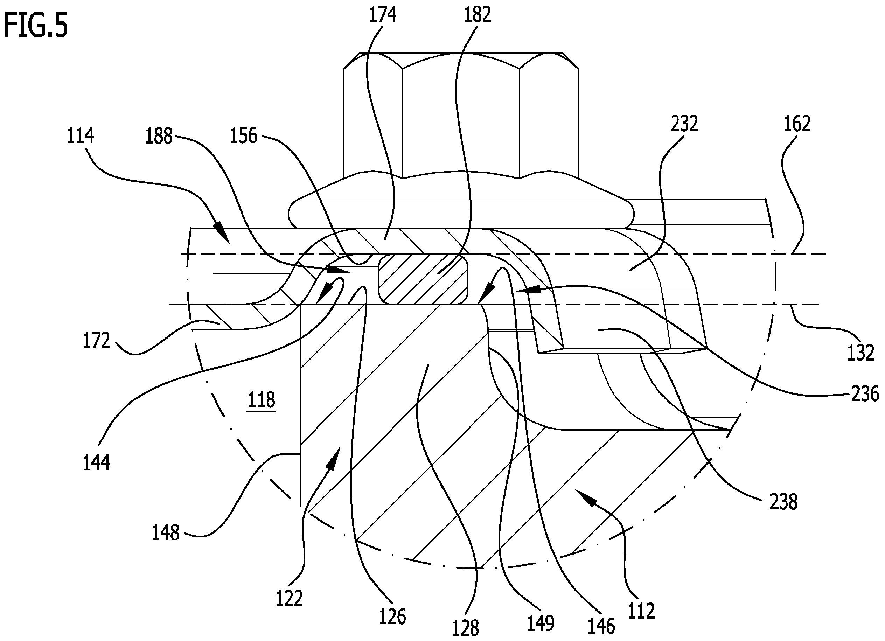

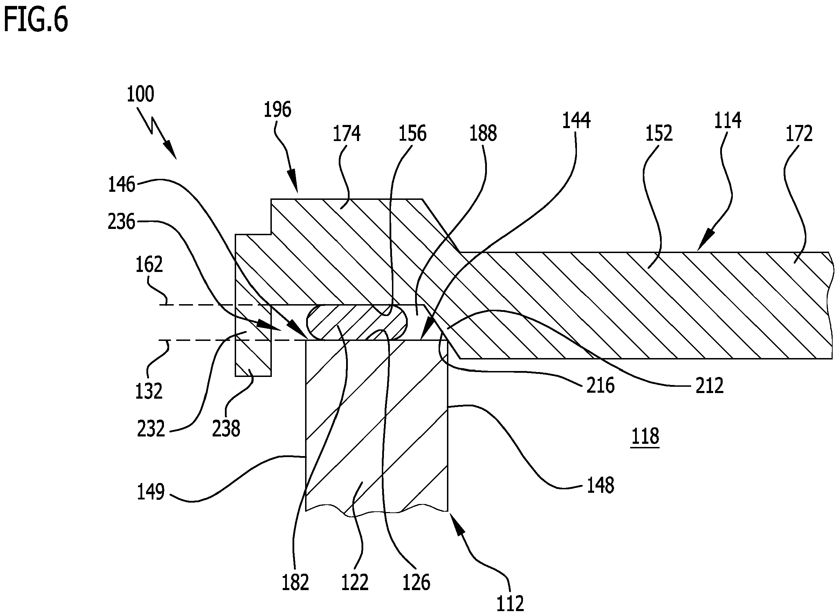

Eine elektrotechnische Vorrichtung umfasst ein als Ganzes mit 100 bezeichnetes Gehäuse, welches beispielhaft in den Fig. 1 bis 6 dargestellt ist.

Das Gehäuse 100 umfasst mehrere Gehäuseteile, zumindest zwei Gehäuseteile 112 und 114, welche einen Innenraum 118 des Gehäuses 100 umgeben. Insbesondere ist der Innenraum 118 eine Aufnahme für eine oder mehrere elektrische Einrichtungen, beispielsweise umfassend elektrische Schaltungen und insbesondere umfassend eine Autobatterie, wobei diese in den Figuren nicht zeichnerisch dargestellt sind.

Das eine Gehäuseteil 112 umfasst eine Umwandung 122, welche den Innenraum 118 zumindest teilweise umgibt. Beispielsweise umgibt die Umwandung 122 den Innenraum 118 größtenteils seitlich mit beispielsweise vier Seitenwandabschnitten.

An einer Verbindungsseite 124 weist die Umwandung 122 eine Verbindungsfläche 126 auf.

Die Verbindungsfläche 126 ist dem anderen Gehäuseteil 114 zugewandt und verläuft insbesondere in einer geometrischen Verbindungsebene 132 bis zu welcher sich ein Teil der Umwandung 122, beispielsweise ein Verbindungsbund 128 derselben, erstreckt.

Die Verbindungsfläche 126 verläuft entlang einer Verbindungskontur 134, die hier in der Verbindungsebene 132 und um eine Gehäuseteilöffnung 142 geschlossen herum verläuft, so dass die Verbindungsfläche 126 die Gehäuseteilöffnung 142 umrandet.

Quer zu der Verbindungskontur 134 erstreckt sich die Verbindungsfläche 126 zwischen einem innenseitigen Randabschnitt 144 und einem äußeren Randabschnitt 146, wobei der innenseitige Randabschnitt 144 insbesondere die Gehäuseteilöffnung 142 begrenzt und an diesem die Verbindungsfläche 126 und eine den Innenraum 118 zumindest teilweise begrenzende innere Wandabschnittsfläche 148 beispielsweise kantenartig zusammentreffen. An dem äußeren Randabschnitt 146 trifft die Verbindungsfläche 126 insbesondere mit einer an einer den Innenraum 118 abgewendeten Außenseite verlaufenden äußeren Wandabschnittsfläche 149 beispielsweise kantenartig zusammen.

Insbesondere erstrecken sich die inneren und äußeren Wandabschnittsflächen 148, 149 schräg, beispielsweise zumindest näherungsweise senkrecht, von der geometrischen Verbindungsebene hinweg.

Der beispielsweise vorgesehene Verbindungsbund 128 erstreckt sich zwischen den inneren und äußeren Wandabschnittsflächen 148 und 149 und ist an den restlichen Teil der Umwandung 122, insbesondere den Seitenwandabschnitten angeformt aber abgesetzt von diesen, so dass deren innere und äußere Seitenwandabschnittsflächen versetzt zu den inneren und äußeren Wandabschnittsflächen 148 und 149 verlaufen. Bei Varianten gehen die innere und äußere Wandabschnittsflächen 148, 149 in die innere beziehungsweise äußere Seitenwandabschnittsfläche unversetzt über.

Beispielsweise weist die Umwandung 122 des einen Gehäuseteils 112 weitere Öffnungen auf, an welche weitere Gehäuseteile angeordnet werden können und/oder durch welche Teile der elektrotechnischen Vorrichtung, beispielsweise Kabel, hindurchgeführt werden können und die elektrotechnische Vorrichtung mittels dieser Teile mit anderen Funktionselementen verbunden werden kann und in einem verbundenen Zustand verbunden ist. Bei anderen Varianten des Ausführungsbeispiels ist vorgesehen, dass die Umwandung 122 im Wesentlichen den Innenraum 118 geschlossen umgibt und lediglich die eine Gehäuseteilöffnung 142 aufweist.

Das andere Gehäuseteil 114 weist ebenfalls eine Umwandung 152 auf, welche an einer Verbindungsseite 154 desselben eine zu der Verbindungsfläche 126 des einen Gehäuseteils 112 korrespondierende Verbindungsfläche 156 aufweist.

Insbesondere erstreckt sich die Verbindungsfläche 156 in einer geometrischen Verbindungsebene 162, welche in einem montierten Zustand des Gehäuses 100 zumindest näherungsweise parallel zu der geometrischen Verbindungsebene 132 des einen Gehäuseteils 112 verläuft. Insbesondere verläuft außerdem die Verbindungsfläche 156 entlang einer Verbindungskontur 164, welche vorzugsweise den gleichen Verlauf aufweist wie die Verbindungskontur 134 des einen Gehäuseteils 112.

Das andere Gehäuseteil 114 ist insbesondere deckelartig korrespondierend zu der Gehäuseteilöffnung 142 des einen Gehäuseteils 112 ausgebildet, wobei zumindest ein Deckelabschnitt 172 der Umwandung 152 in dem geschlossenen Zustand des Gehäuses 100 im Wesentlichen die Gehäuseteilöffnung 142 abdeckt und ein die Verbindungsfläche 156 ausbildendes Verbindungsteil 174 der Umwandung 152 um den Deckelabschnitt 172 geschlossen herum verläuft.

Insbesondere ist das beispielsweise deckelartig ausgebildete andere Gehäuseteil 114 als im Wesentlichen flaches Wandteil ausgebildet, welches sich im Wesentlichen in zwei zueinander senkrecht verlaufenden Erstreckungsrichtungen erstreckt und in eine zu den beiden Erstreckungsrichtungen senkrecht verlaufende Ausdehnungsrichtung eine erheblich kleinere Ausdehnung aufweist. Die beiden Erstreckungsrichtungen verlaufen vorzugsweise zumindest näherungsweise parallel zur geometrischen Verbindungsebene 162.

Außerdem ist ein Dichtelement 182 an den Verbindungsflächen 126, 156 entlang den Verbindungskonturen 134, 164 vorgesehen, welches insbesondere an einem der Gehäuseteile 112, 114, hier an dem insbesondere deckelartigen Gehäuseteil 114, verliersicher angeordnet ist. Beispielsweise ist das Dichtelement 182 klebend fest mit dem Gehäuseteil 112, 114 verbunden.

Vorzugsweise ist das Dichtelement 182 als Elastomerdichtung ausgebildet, und beispielsweise als Dichtraupe auf eines der Gehäuseteile 112, 114, insbesondere an dessen Verbindungsfläche 126, 156, aufgebracht.

Das Dichtelement 182 ist zur Medienabdichtung zwischen den zwei Gehäuseteilen 112, 114 im geschlossenen Zustand vorgesehen und dichtet einen Spalt 188 zwischen den beiden Verbindungsflächen 126, 156 der zwei Gehäuseteile 112, 114 mediendicht in dem geschlossenen Zustand ab und ist insbesondere somit gegenüber Wasser, Feuchtigkeit und weiteren Flüssigkeiten und beispielsweise gegen kleine feste Partikel, wie beispielswese Dreck- Staub-, und/oder Abriebspartikel abdichtend ausgebildet.

Somit verlaufen bei dem Gehäuse 100 in dessen geschlossenem Zustand in einem Verbindungsabschnitt 196 Abschnitte der zwei Gehäuseteile 112, 114, die die Verbindungsflächen 126, 156 ausbilden, zueinander korrespondierend entlang der Verbindungskonturen 134, 164 und deren Verbindungsflächen 126, 156 sind einander zugewandt und zwischen diesen ist der Spalt 188 ausgebildet, welcher durch das Dichtelement 182 zumindest näherungsweise mediendicht verschlossen ist. Insbesondere verläuft der Verbindungsabschnitt 196 umfangseitig geschlossen um die Gehäuseteilöffnung 142 herum, welche in dem geschlossenen Zustand von dem Deckelabschnitt 172 abgedeckt ist und somit durch das andere Gehäuseteil 114, insbesondere zusammen mit dem Dichtelement 182 mediendicht zumindest näherungsweise verschlossen ist.

Die zumindest zwei Gehäuseteile 112, 114 sind insbesondere aus einem metallischen Werkstoff ausgebildet.

Insbesondere ist das eine Gehäuseteil 112 ein Gussteil, bei welchem die Verbindungsfläche 126 nachbearbeitet, beispielsweise überfräst ist und somit geringere Toleranzen aufweist als die nicht nachbearbeiteten Wandabschnittsflächen 148, 149.

Das andere Gehäuseteil 114 ist insbesondere aus einem Flachmaterial, beispielsweise einem Blech, hergestellt und wird vorzugsweise in seine Endform umgeformt.

Für eine EMV-Abschirmung weist eines der Gehäuseteile 112, 114, bei diesem Ausführungsbeispiel das insbesondere deckelartige Gehäuseteil 114, einen als integrierten Abschirmungsabschnitt 212 ausgebildeten Schutzabschnitt auf, welcher entlang des Verbindungsabschnitts 196 zumindest abschnittsweise und vorzugsweise vollständig entlang des Verbindungsabschnitts 196 das gegenüberliegende Gehäuseteil 112 kontaktiert.

Bei diesem Ausführungsbeispiel ist der Abschirmungsabschnitt 212 ein umgeformter Abschnitt des Gehäuseteils 114, insbesondere seiner Umwandung 152.

Der Abschirmungsabschnitt 212 umfasst eine Kontaktierungsfläche 216, welche an gegenüberliegenden einen Gehäuseteil 112 anliegt und den innenseitigen Randabschnitt 144, beispielsweise eine Kante desselben, insbesondere kraftbeaufschlagt kontaktiert.

Der Abschirmungsabschnitt 212 verläuft dabei leicht innenraumseitig versetzt zu der Verbindungskontur 164 und ist zwischen dem Deckelabschnitt 172 und dem die Verbindungsfläche 156 ausbildenden Abschnitt der Umwandung 152 angeordnet und verbindet diese Abschnitte.

Insbesondere ist der Abschirmungsabschnitt 212 an den Abschnitt mit der Verbindungsfläche 156 angeformt und erstreckt sich schräg zu diesem und der geometrischen Verbindungsebene 162, beispielsweise in einem Winkel zwischen 30° und 70°, von diesem hinweg in Richtung zu dem gegenüberliegenden Gehäuseteil 112 und insbesondere soweit, dass in dem geschlossenen Zustand des Gehäuses 100 der Abschirmungsabschnitt 212 über die geometrische Verbindungsebene 132 der anderen Verbindungsfläche 126 hinausragt und zumindest mit einem kleinen Abschnitt in die Gehäuseteilöffnung 142 eingreift.

An einer Seite des Abschirmungsabschnitts 212, welche dessen dem Abschnitt 174 mit der Verbindungsfläche 156 zugewandten Seite gegenüberliegend angeordnet ist, ist der Abschirmungsabschnitt 212 insbesondere an den Deckelabschnitt 172 angeformt, wobei in dem geschlossenen Zustand insbesondere der Deckelabschnitt 172 zumindest näherungsweise parallel zu der geometrischen Verbindungsfläche 132 verläuft und beispielsweise seitlich des Verbindungsbundes 128 zumindest teilweise in der Gehäuseteilöffnung 142 angeordnet ist und der Abschirmungsabschnitt 212 mit seinem in die Gehäuseöffnung 142 eingreifenden Bereich an den Deckelabschnitt 172 angeformt ist.

Dabei ist die Kontaktierungsfläche 216 auf der gleichen Seite der Umwandung 152 angeordnet wie die Verbindungsfläche 156 und eine dem Innenraum 118 zugewandte Innenfläche des Deckelabschnitts 172.

Erfindungsgemäß weist das Gehäuseteil 114 einen weiteren als Abdeckungsabschnitt 232 ausgebildeten Schutzabschnitt auf, welcher auf einer dem Innenraum 118 abgewendeten Außenseite 236 den Spalt 188 entlang des Verbindungsabschnitts 196 zumindest teilweise abdeckt.

Vorzugsweise ist der Abdeckungsabschnitt 232 als umgeformter Abschnitt des insbesondere deckelartigen Gehäuseteils 114 ausgebildet.

In dem geschlossenen Zustand erstreckt sich der Abdeckungsabschnitt 232 mindestens zwischen den beiden geometrischen Verbindungsebenen 132 und 162 und vorzugsweise überragt er beidseitig diese. Insbesondere ist der Abdeckungsabschnitt 232 an den Abschnitt 174 mit der Verbindungsfläche 156 angeformt und erstreckt sich von diesem hinweg in Richtung zu dem gegenüberliegend angeordneten Gehäuseteil 112, wobei insbesondere ein Endbereich 238 des Schutzabschnitts 232 außenseitig überlappend mit einem Abschnitt des Gehäuseteils 212, insbesondere des Verbindungsbundes 128, vor zumindest einem Teil der äußeren Wandabschnittsfläche 149 angeordnet ist.

Bei einigen Varianten kontaktiert der Abdeckungsabschnitt 232, insbesondere mit seinem Endbereich 238, zumindest teilweise das gegenüberliegende Gehäuseteil 112, beispielsweise an seiner äußeren Wandabschnittsfläche 149, wodurch insbesondere die EMV-Abschirmung verbessert wird. Bei anderen Varianten ist insbesondere in dem überlappenden Bereich zwischen dem Abdeckungsabschnitt 232, insbesondere seinem Endbereich 238, und dem gegenüberliegenden Gehäuseteil 112, insbesondere der äußeren Wandabschnittsfläche 149, ein kleiner Spalt vorgesehen, wodurch größere Toleranzen an dem gegossenen Gehäuseteil 112 besser ausgeglichen werden können und eine Montage der Gehäuseteile 112, 114 vereinfacht wird und potentielle Spannungen zumindest vermindert werden.

Die Gehäuseteile 112 und 114 werden mittels Befestigungsmitteln 252 an Befestigungsstellen 254 miteinander verbunden. Insbesondere werden die Gehäuseteile 112 und 114 mittels Schrauben als Befestigungsmittel 252 an Schraublöchern aufweisenden Befestigungsstellen 254 miteinander verschraubt.

Vorzugsweise sind die Befestigungsstellen 254 relativ zu dem Innenraum 118 außenseitig zu den Verbindungskonturen 134 und 164 angeordnet, wobei bei dieser Variante des Ausführungsbeispiels die Befestigungsstellen 254 zwischen den Verbindungskonturen 134 und 164 einerseits und der Kontur entlang welcher der Abdeckungsabschnitt 232 andererseits verläuft angeordnet sind.

Beispielsweise weist das eine Gehäuseteil 112, insbesondere an seinem Verbindungsbund 128, Wandverdickungen auf, welche mit Schraublöchern versehen sind.

Das andere, insbesondere deckelartig ausgebildete, Gehäuseteil 114 weist an den Befestigungsstellen 254 beispielsweise Flanschvorsprünge auf, welche insbesondere mit Durchbrüchen für die Befestigungsmittel 252 versehen sind. Vorzugsweise sind dabei außenseitig die Flanschvorsprünge mit Teilabschnitten des Abdeckungsabschnittes 232 versehen.

Insbesondere mittels der Befestigungsmittel 252 werden in dem geschlossenen Zustand die zwei Gehäuseteile 112, 114 zumindest leicht aneinander gepresst, so dass das Dichtelement 182 zwischen diesen beiden, insbesondere zwischen den beiden Verbindungsflächen 126 und 156, verpresst wird und so in besonders günstiger Weise in dem Spalt 188 abdichtend wirkt.

Außerdem wird der Abschirmungsabschnitt 212 kraftbeaufschlagt an das gegenüberliegend angeordnete Gehäuseteil 112 angelegt, so dass durch die Kraftbeaufschlagung und eine flexible Eigenelastizität des Abschirmungsabschnitts 212 dieser zumindest näherungsweise vollständig entlang des Verbindungsabschnitts 196 das gegenüberliegend angeordnete Gehäuseteil 114 auch bei großen Toleranzen kontaktiert.

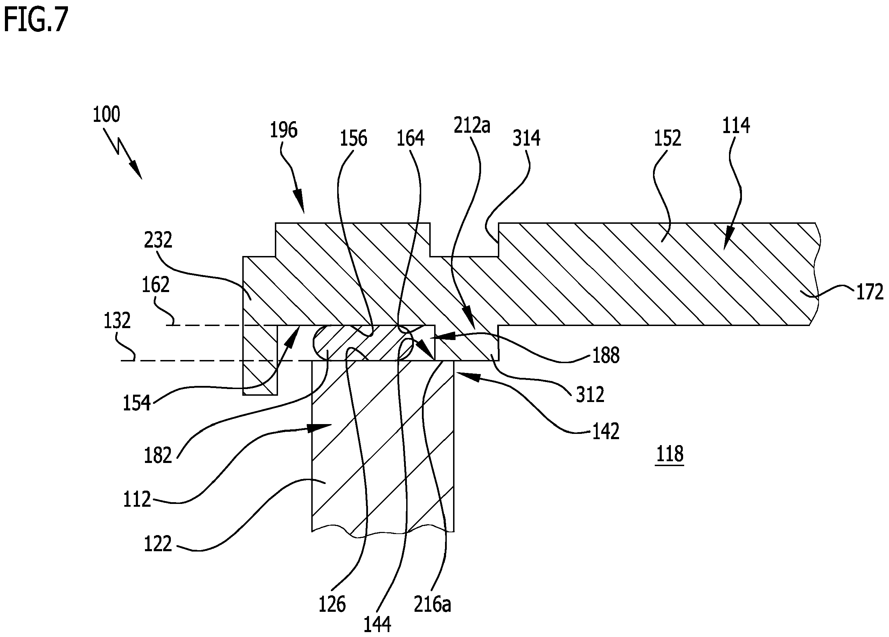

Bei einem zweiten bis sechsten Ausführungsbeispiel, beispielhaft dargestellt in Fig. 7 bis 11, umfasst ein Gehäuse 100 mindestens zwei Gehäuseteile 112, 114, welche einen Innenraum 118 zumindest teilweise umgeben und entlang eines Verbindungsabschnitts 196 jeweils Abschnitte aufweisen, die in einem geschlossenen Zustand des Gehäuses einander zugewandt sind. Beispielsweise ist das Gehäuse 100 mit den zumindest zwei Gehäuseteilen 112, 114 zumindest im Wesentlichen wie bei dem ersten Ausführungsbeispiel ausgebildet und weist eines oder mehrere der im Zusammenhang mit dem ersten Ausführungsbeispiel erläuterten Merkmale auf, insbesondere bezüglich der Verbindungsflächen 126, 156 und/oder der Umwandungen 122, 152 und/oder der geometrischen Verbindungsebenen 132, 162 und/oder dem Verbindungsbund 128 und/oder dem Deckelabschnitt 172. Insbesondere ist bei diesen Ausführungsbeispielen auch ein Dichtelement 182, beispielsweise mit einem oder mehreren der voranstehend im Zusammenhang mit dem ersten Ausführungsbeispiel erläuterten Merkmalen, vorgesehen.

Elemente die zumindest im Wesentlichen gleich ausgebildet sind und/oder die zumindest grundlegende gleiche Funktion erfüllen, sind voranstehend und nachfolgend mit dem gleichen Bezugszeichen versehen. Insbesondere wenn auf eine alternative Ausgestaltung bei einem Ausführungsbeispiel besonders hingewiesen werden soll, ist dem Bezugszeichen ein sich auf das entsprechende Ausführungsbeispiel beziehender Buchstabe als Suffix angehängt.

Bei dem zweiten Ausführungsbeispiel, welches beispielhaft schematisch in der Fig. 7 dargestellt ist, weist das insbesondere deckelartig ausgebildete Gehäuseteil 114 zumindest einen als Abschirmungsabschnitt 212a ausgebildeten Schutzabschnitt auf, welcher in das Gehäuseteil 114 eingeprägt ist.

Der eingeprägte Schutzabschnitt, hier der Abschirmungsabschnitt 212a, weist ein aus der Verbindungsseite 154 und insbesondere über die geometrische Verbindungsebene 162 hervorstehendes sich in Richtung des gegenüberliegend angeordneten Gehäuseteils 112 erstreckendes Prägeteil 312 auf. Insbesondere wird das Prägeteil 312 durch ein Prägen durch das Gehäuseteil 114 hindurch gefertigt, so dass eine der Verbindungsseite 154 gegenüberliegende Seite des Gehäuseteils 114 eine dem Prägeteil 312 gegenüberliegend verlaufende und zu diesem korrespondierend ausgebildete Einfurchung 314 aufweist.

Der geprägte Abschnitt weist an seinem Prägeteil 312 eine dem gegenüberliegend angeordneten Gehäuseteil 112 zugewandte Kontaktierungsfläche 216a auf, die beispielsweise zumindest näherungsweise parallel zu der geometrischen Verbindungsebene 162 und im Wesentlichen entlang der Verbindungskontur 164 verläuft. In dem geschlossenen Zustand kontaktiert das Prägeteil 312 mit seiner Kontaktierungsfläche 216a zumindest näherungsweise vollständig entlang des Verbindungsabschnitts 196 das gegenüberliegend angeordnete Gehäuseteil 122 insbesondere an dem innenseitigen Randabschnitt 144, wobei vorzugsweise die Kontaktierungsfläche 216a zumindest teilweise auf der Verbindungsfläche 226 insbesondere kraftbeaufschlagt aufliegt.

Vorzugsweise ist der eingeprägte Abschnitt federnd ausgebildet, so dass dieser mit seiner Federwirkung zu einer durchgängig guten Kontaktierung beiträgt.

Beispielsweise ist der geprägte Abschnitt als eine Sicke ausgebildet.

Vorzugsweise ist der eingeprägte Abschnitt 212a innenraumseitig angeordnet und stützt sich beispielsweise am innenseitigen Randabschnitt 144ab. Damit verläuft insbesondere der eingeprägte Abschnitt entlang der Verbindungsfläche 156 und zwischen dem die Verbindungsfläche 156 aufweisenden Abschnitt 174 und dem Deckelabschnitt 172 des Gehäuseteils 114.

Besonders günstig ist es, wenn bei diesem Ausführungsbeispiel das Gehäuseteil 114 auch einen außenseitigen als Abdeckungsabschnitt 232 ausgebildeten Schutzabschnitt aufweist. Dieser ist vorzugsweise zumindest im Wesentlichen wie im Zusammenhang mit dem ersten Ausführungsbeispiel erläutert ausgebildet, so dass auf diese Ausführungen vollinhaltlich verwiesen wird.

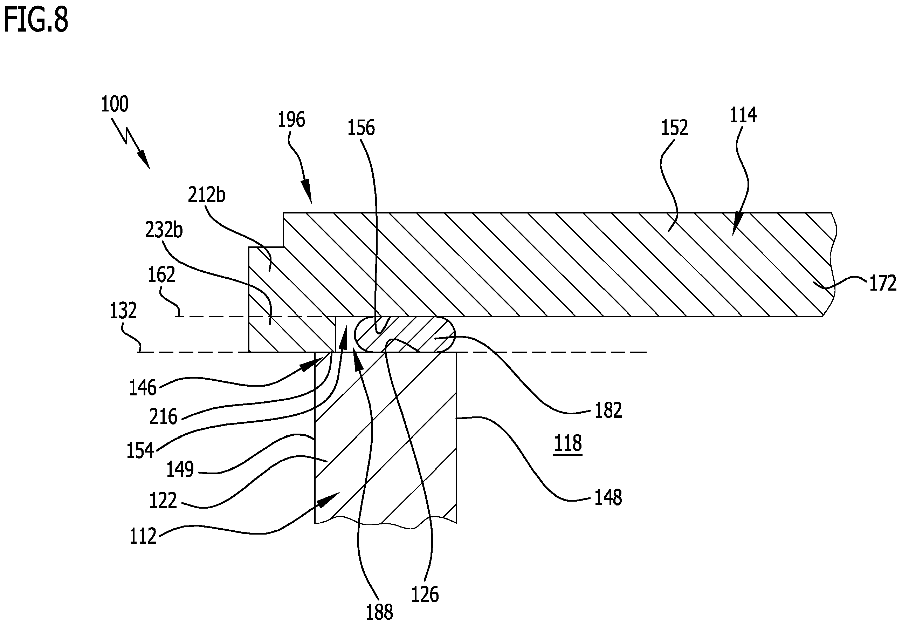

Bei einem dritten Ausführungsbeispiel, welches beispielhaft schematisch in Fig. 8 dargestellt ist, weist das insbesondere deckelartig ausgebildete Gehäuseteil 114 einen kombiniert als Abschirmungsabschnitt 212b und Abdeckungsabschnitt 232b ausgebildeten Schutzabschnitt auf, welcher an der dem Innenraum 118 abgewendeten Außenseite vorgesehen ist.

Bei einigen Varianten ist dieser außenseitige Abschnitt als abgescherter Rand des Gehäuseteils, insbesondere dessen Umwandung 172, ausgebildet. Bei anderen Varianten des Ausführungsbeispiels ist dieser Schutzabschnitt als ein umgeformter Abschnitt des Gehäuseteils 114, insbesondere dessen Umwandung 172, ausgebildet.

Ein Teil des Schutzabschnittes 212b, 232b ragt aus der Verbindungsseite 154 des Gehäuseteils 114 heraus, insbesondere über die geometrische Verbindungsebene 162 hinaus, und erstreckt sich in Richtung dem gegenüberliegend angeordneten Gehäuseteil 112, welches dieser Abschnitt 212b, 232b vorzugsweise zumindest näherungsweise durchgängig entlang des Verbindungsabschnitts 196 kontaktiert.

Der Schutzabschnitt 212b, 232b weist eine Kontaktierungsfläche 216 auf, an welcher dieser das gegenüberliegend angeordnete Gehäuseteil 112 kontaktiert. Bei der beispielhaft in Fig. 8 dargestellten Variante liegt der Schutzabschnitt 212b, 232b mit der Kontaktierungsfläche 216 insbesondere kraftbeaufschlagt auf zumindest einem Teil der Verbindungsfläche 126 des gegenüberliegend angeordneten Gehäuseteils 112 auf.

Insbesondere liegt die Kontaktierungsfläche 216 des Schutzabschnitts 212b, 232b an dem äußeren Randabschnitt 146, beispielsweise an einer äußeren Kante desselben an. Bei anderen Varianten ist vorgesehen, dass der außenseitige Schutzabschnitt 212b, 232b eine inwärts gerichtete Kontaktierungsfläche aufweist, die die äußere Wandabschnittsfläche 149 des gegenüberliegend angeordneten Gehäuseteils 112 kontaktiert.

Insbesondere erstreckt sich der Schutzabschnitt 212b, 232b aus seinem Gehäuseteil 114 über dessen geometrische Verbindungsebene 162 hinaus im geschlossenen Zustand bis mindestens zur geometrischen Verbindungsebene 132 des gegenüberliegend angeordneten Gehäuseteils 112 und deckt somit den Spalt 188 zwischen den Verbindungsflächen 126 und 156 außenseitig ab.

Auch bei diesem Ausführungsbeispiel ist ein Dichtelement 182 vorgesehen, welches in dem geschlossenen Zustand zwischen den Verbindungsflächen 126 und 156 abdichtend wirkt, und welches relativ zu dem Schutzabschnitt 212b, 232b innseitig zu dem Innenraum 118 hin angeordnet ist. Insbesondere ist das Dichtelement 182 zumindest im Wesentlichen gleich wie bei den voranstehend erläuterten Ausführungsbeispielen ausgebildet, so dass bezüglich vorteilhaften Ausbildungen desselben auf die voranstehenden Erläuterungen hierzu vollinhaltlich verwiesen wird.

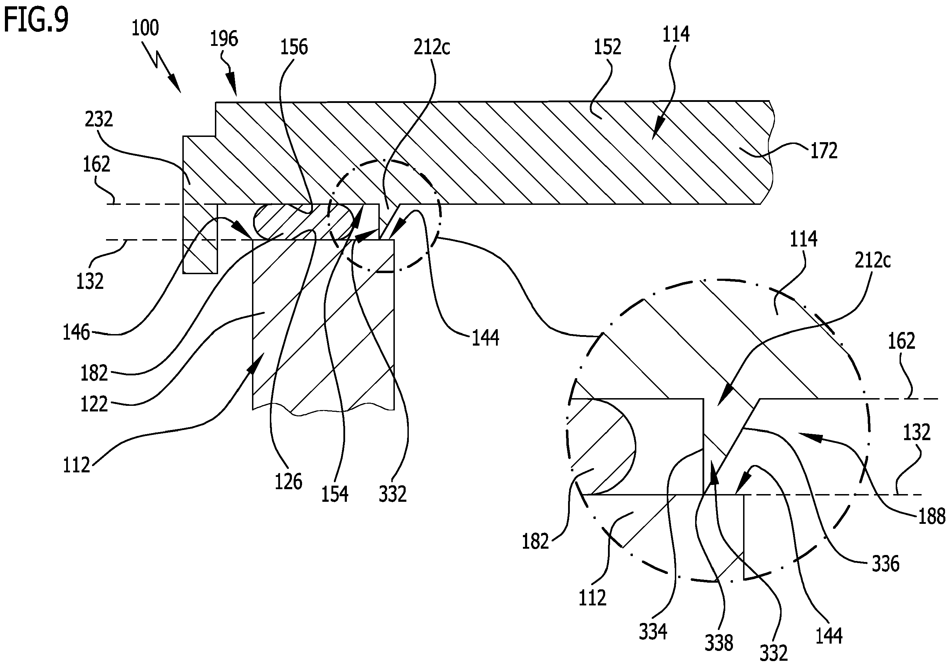

Bei einem vierten Ausführungsbeispiel, welches beispielhaft schematisch in der Fig. 9 dargestellt ist, weist das insbesondere deckelartig ausgebildete Gehäuseteil 114 einen als Abschirmungsabschnitt 212c ausgebildeten Schutzabschnitt mit einer abgeschrägten Kante 332 auf, wobei die Kante 332 an das gegenüberliegende Gehäuseteil 112, insbesondere in die Verbindungsfläche 126, in dem geschlossenen Zustand gepresst wird.

Dabei steht der Abschnitt mit der Kante 332 an der Verbindungsseite 154 insbesondere über die Verbindungsfläche 156 hervor mit einer Erstreckung, die mindestens so groß ist wie eine von dem einen zu dem anderen Gehäuseteil 112, 114 gemessene Höhenausdehnung des Spaltes 188 in dem geschlossenen Zustand. Insbesondere ist die Erstreckung dieses Abstandes mindestens so groß wie der Abstand der geometrischen Verbindungsebenen 162, 132 in dem geschlossenen Zustand.

Der im Querschnitt beispielsweise dornartig ausgebildete Abschnitt mit der Kante 332 weist zwei an der Kante 332 einander zulaufende Scheitelflächen 334, 336 auf, welche an einem abstehenden Ende der Kante 332 in einer Kantenspitze 338 spitz aufeinander zutreffen.

In dem geschlossenen Zustand erstreckt sich damit der Schutzabschnitt 212c von seinem Gehäuseteil 114 bis zu dem gegenüberliegenden Gehäuseteil 112 und wird mit der Kantenspitze 338 auf dieses aufgepresst und insbesondere im Bereich der Verbindungsfläche 126 in dieses mit der Kantenspitze 338 eingepresst. Somit überbrückt der die Kante aufweisende Abschnitt 212c in dem geschlossenen Zustand den Spalt 188 und kontaktiert vorzugsweise zumindest näherungsweise vollständig entlang des Verbindungsabschnitts 196 das gegenüberliegende Gehäuseteil 112.

Bei diesem Ausführungsbeispiel ist der Abschnitt 212c relativ zu dem Dichtelement 182 innenseitig angeordnet und kontaktiert den innenseitigen Randabschnitt 144. Bei anderen Varianten des Ausführungsbeispiels ist vorgesehen, dass dieser Abschnitt 212c mit der Kante 332 relativ zu dem Dichtelement 182 außenseitig, beispielsweise den äußeren Randabschnitt 146 kontaktierend, angeordnet ist und wirkt dabei alternativ oder ergänzend als Abdeckungsabschnitt.

Vorzugsweise ist bei dem Ausführungsbeispiel, insbesondere bei der Variante mit dem innenseitigen Abschnitt 212c mit der Kante 332, zusätzlich noch ein als Abdeckungsabschnitt 232 ausgebildeter äußerer Schutzabschnitt vorgesehen. Insbesondere ist dieser äußere Schutzabschnitt zumindest im Wesentlichen wie bei einem der voranstehend erläuterten Ausführungsbeispiele mit einem oder mehreren der dabei erläuterten Merkmalen ausgebildet, so dass vollinhaltlich auf die voranstehenden Ausführungen verwiesen wird.

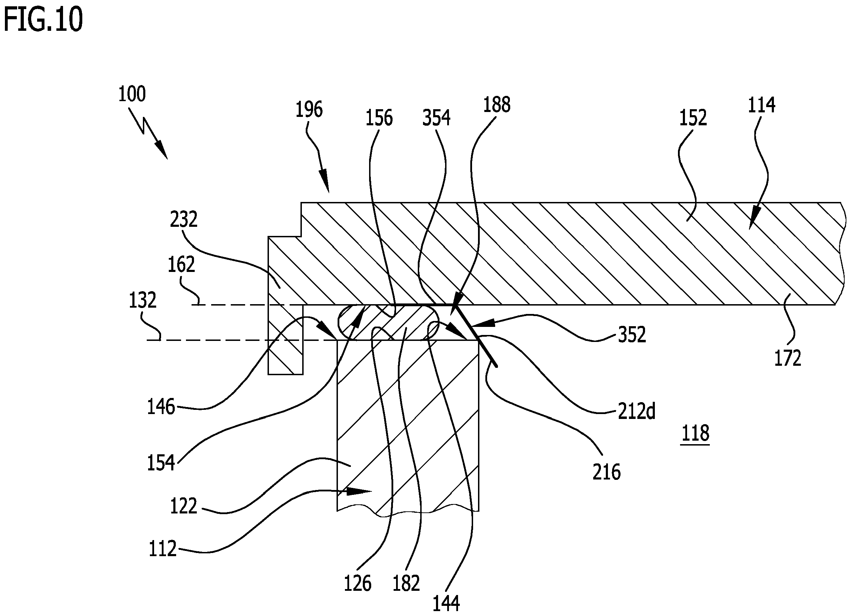

Bei einem fünften Ausführungsbeispiel, welches in der Fig. 10 beispielhaft schematisch dargestellt ist, wird der integrierte Schutzabschnitt durch einen Abschirmungsabschnitt 212d eines mit dem Gehäuseteil 114 verbundenen Schutzelements 352, welches vorzugsweise eine metallische Lage ist, ausgebildet.

Dabei weist die metallische Lage einen Halteabschnitt 354 auf, an welchem sie an der Verbindungsseite 154 mit dem Gehäuseteil 114 verbunden ist.

Insbesondere ist der Halteabschnitt 354 flach ausgebildet und liegt an der Verbindungsfläche 156 an.

Beispielsweise ist das Schutzelement 352 lediglich durch die Beaufschlagung des Halteabschnitts 354durch das Dichtelement 182, welche insbesondere durch die Befestigungsmittel 252 erfolgt, mit dem Gehäuseteil 114 verbunden, wobei bei bevorzugten Varianten des Ausführungsbeispiels das Schutzelement 352 bereits vor der Montage des Gehäuses 100 verliersicher an das insbesondere deckelartige Gehäuseteil 114 angeordnet wird, beispielsweise durch Schweißen, insbesondere durch Punktschweißen.

Der Abschirmungsabschnitt 212d ist an den Halteabschnitt 354 angeformt und ein umgeformter Abschnitt der das Schutzelement 352 ausbildenden metallischen Lage.

Insbesondere ist der Abschirmungsabschnitt 212d ein schräg von dem Halteabschnitt 354 abstehender Abschnitt.

Der Abschirmungsabschnitt 212d erstreckt sich von einem an dem Gehäuseteil 114 anliegenden Endbereich von der Verbindungsseite 154 des Gehäuseteils 114 hinweg bis zu einem zweiten Endbereich, wobei die Erstreckung des Abschirmungsabschnitts 212d von dem Gehäuseteil 114 hinweg mindestens so groß ist, dass der zweite Endbereich mindestens der Höhenausdehnung des Spalts 188 in dem geschlossenen Zustand entsprechend entfernt von der Verbindungsseite 154 ist.

Der Abschirmungsabschnitt 212 weist eine dem gegenüberliegenden Gehäuseteil 112 zugewandte Kontaktierungsfläche 216 auf, an welcher dieser zumindest näherungsweise vollständig entlang des Verbindungsabschnitts 196 das Gehäuseteil 112 kontaktiert. Beispielsweise ist das Schutzelement 352 so mit dem Gehäuseteil 114 verbunden, dass in dem geschlossenen Zustand dessen Kontaktierungsfläche 216 den innenseitigen Randabschnitt 144, insbesondere eine Kante desselben, des gegenüberliegenden Gehäuseteils 112 kontaktiert. Hierbei ist es günstig, wenn der Abschirmungsabschnitt 212d in dem geschlossenen Zustand innerhalb des Spaltes 188 an dem Gehäuseteil 114 anliegt und schräg zur Richtung der Höhenausdehnung des Spalts 188 sich zumindest bis zu dem gegenüberliegend angeordneten Gehäuseteil 112 erstreckt und mit einem Endbereich aus dem Spalt 188 hinausragt und dabei mit der dem gegenüberliegenden Gehäuseteil 112 zugewandten Kontaktierungsfläche 216 dieses insbesondere federnd kraftbeaufschlagt kontaktiert.

Vorzugsweise ist dabei der Abschirmungsabschnitt 212d durch die Beaufschlagung der Gehäuseteile 112, 114 im Vergleich zu einem unbeaufschlagten Zustand verformt, insbesondere elastisch verformt.

Der Abschirmungsabschnitt 212d ist innenraumseitig in dem Spalt 188 angeordnet und damit zwischen einem in dem Spalt 188 angeordneten Dichtelement 182 und dem Innenraum 118 angeordnet. Bei Varianten des Ausführungsbeispiels ist der Abschirmungsabschnitt 212d außenseitig, insbesondere den äußeren Randabschnitt 146 kontaktierend, entsprechend angeordnet.

Besonders günstig ist es, wenn das Dichtelement 182 zum einen abdichtend an der Verbindungsfläche 126 des einen Gehäuseteils 112 anliegt und auf der gegenüberliegenden Seite abdichtend teilweise an der Verbindungsfläche 156 des anderen Gehäuseteils 114 und an dem Halteabschnitt 354 des Schutzelements 352 anliegt.

Vorzugsweise weist das Gehäuseteil 114 ferner einen Abdeckungsabschnitt 232 auf, welcher insbesondere zumindest im Wesentlichen wie bei einem der voranstehend erläuterten Ausführungsbeispiele ausgebildet ist und insbesondere eines oder mehrere der im Zusammenhang mit diesen erläuterten Merkmale aufweist, so dass vollinhaltlich auf die voranstehenden Ausführungen zu diesem verwiesen wird.

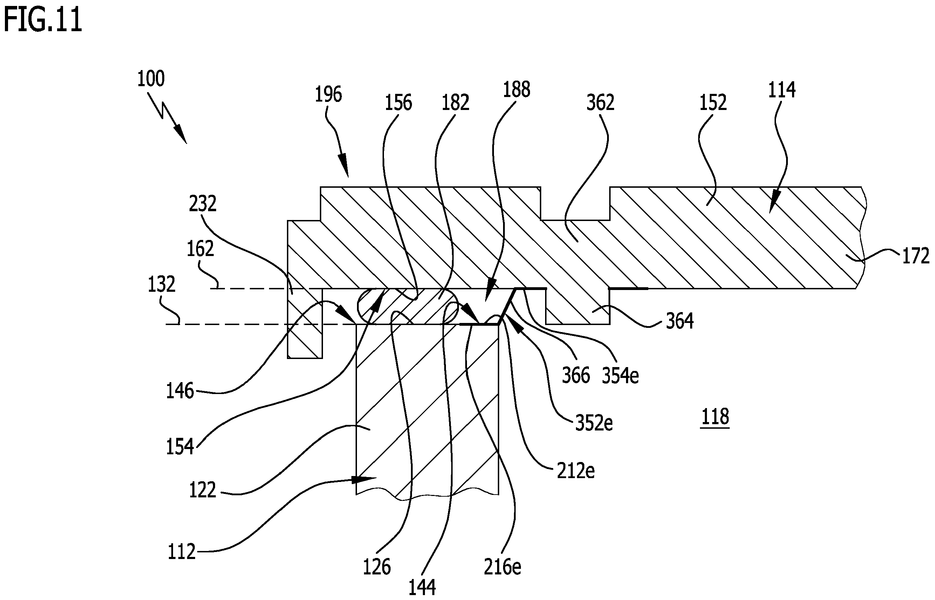

Bei einem sechsten Ausführungsbeispiel, welches beispielhaft schematisch in Fig. 11 dargestellt ist, ist ein den integrierten Schutzabschnitt ausbildendes Schutzelement 352e mit dem Gehäuseteil 114 verbunden, insbesondere mittels Durchsetzfügen verbunden. Dabei ist das Schutzelement 352e vorzugsweise aus einem metallischen Flachmaterial ausgebildet.

Dabei liegt ein Halteabschnitt 354e des Schutzelements 352e an der Verbindungsseite 154 des Gehäuseteils 114 an einem Fügeabschnitt 362 desselben an und in diesem Bereich sind der Halteabschnitt 354e und der Fügeabschnitt 362e zumindest teilweise kraft- und/oder formschlüssig miteinander verbunden.

Insbesondere ist der Fügeabschnitt 362 ein umgeformter Abschnitt des Gehäuseteils 114, wobei dieser an Fügestellen an der Verbindungsseite 154 aus der Verbindungsseite 154 heraus quellende die Verbindung mit dem Halteabschnitt 354e ausbildende Materialanhäufungen 364 aufweist und insbesondere an einer der Verbindungsseite 154 gegenüberliegenden Seite an den Fügestellen korrespondierende Einfurchungen aufweist. Insbesondere weist der Halteabschnitt 354e Durchbrüche auf, durch welche die Materialanhäufungen 364 hindurchgreifen und diese beidseitig umgreifen um die verliersichere Verbindung herzustellen.

Beispielsweise ist der Fügeabschnitt 362 Teil des Deckelabschnitts 172. Bei anderen günstigen Varianten des Ausführungsbeispiels ist der Fügeabschnitt 362 zwischen dem Deckelabschnitt 172 und dem die Verbindungsfläche 176 ausbildenden Abschnitt 174 des Gehäuseteils 114 angeordnet.

Ferner weist das Schutzelement 352e einen als Abschirmungsabschnitt 212e ausgebildeten Schutzabschnitt auf, welcher insbesondere vollflächig mit einer Kontaktierungsfläche 216e auf der Verbindungsfläche 126 des gegenüberliegend angeordneten Gehäuseteils 112, insbesondere an dem innenseitigen Randabschnitt 144, aufliegt. Insbesondere sind der Halteabschnitt 354e und der Abschirmungsabschnitt 212e mittels eines die Distanz zwischen den Gehäuseteilen 114 und 112 überbrückenden Brückenabschnitt 366 miteinander verbunden. Vorzugsweise erstrecken sich dabei der Halteabschnitt 354e und der Abschirmungsabschnitt 212e zumindest näherungsweise parallel zueinander und der Brückenabschnitt 366 erstreckt sich schräg zu diesen Abschnitten 354e, 212e zwischen diesen und geht an Kantenabschnitten in diese über. Insbesondere weist somit das Schutzelement 352 entlang des Verbindungsabschnitts 196 bei diesem Ausführungsbeispiel eine Halbsicke auf, wobei die Sickenfüße die Kantenabschnitte ausbilden.

Besonders günstig ist es, wenn der Halteabschnitt 354e und der Abschirmungsabschnitt 212e in einem unverbauten Abstand einen größeren Abstand, welcher insbesondere zumindest näherungsweise senkrecht zu deren im Wesentlichen paralleler Erstreckung gemessen wird, aufweisen als in dem geschlossenen Zustand des Gehäuses 100, so dass dieser Bereich des Schutzelements 352, vorzugsweise an dem Brückenabschnitt 366, im geschlossenen Zustand insbesondere elastisch verformt ist und beaufschlagend an den Gehäuseteilen 114 und 112 anliegen.

Das Schutzelement 352e ist innenraumseitig zwischen den Gehäuseteilen 114 und 112 angeordnet und zumindest der Abschirmungsabschnitt 212e ragt in den Spalt 188 hinein. Damit ist das Schutzelement 352e zwischen dem Innenraum 118 und einem in dem Spalt 188 angeordneten Dichtelement 182 angeordnet.

Das Dichtelement 182 liegt in dem geschlossenen Zustand des Gehäuses 100 abdichtend an den Verbindungsflächen 126 und 156 der zwei Gehäuseteile 112, 114 an, und bei einigen Varianten des Ausführungsbeispiels auch an dem Schutzelement 352e, insbesondere dem Abschirmungsabschnitt 212e an.

Das Dichtelement 182 ist insbesondere zumindest im Wesentlichen wie bei den voranstehend erläuterten Ausführungsbeispielen ausgebildet und weist insbesondere eines oder mehrere der voranstehend erläuterten Merkmale auf, so dass diesbezüglich vollinhaltlich auf die voranstehenden Ausführungen Bezug genommen wird.

Außerdem weist das Gehäuseteil 114 vorzugsweise einen als Abdeckungsabschnitt 232 ausgebildeten Schutzabschnitt auf, welcher außenseitig angeordnet ist und insbesondere zumindest im Wesentlichen wie bei den voranstehend erläuterten Ausführungsbeispielen ausgebildet ist und vorzugsweise eines oder mehrerer der dabei erläuterten Merkmale aufweist, so dass diesbezüglich auf die voranstehenden Ausführungen vollinhaltlich verwiesen wird.

Im Übrigen sind Elemente und Merkmale, soweit nicht anders und/oder detaillierter im Zusammenhang mit einem der voranstehenden Ausführungsbeispiele erläutert, wie bei einem anderen der voranstehend erläuterten Ausführungsbeispiele, insbesondere wie bei dem Ausführungsbeispiel 1, ausgebildet, so dass auf die jeweiligen Ausführungen vollinhaltlich Bezug genommen wird.

Insbesondere sind, beispielsweise innenseitige und außenseitige, Schutzabschnitte, insbesondere Abdeckungsabschnitte und Abschirmungsabschnitte, die im Zusammenhang mit unterschiedlichen Ausführungsbeispielen erläutert wurden, miteinander kombinierbar.

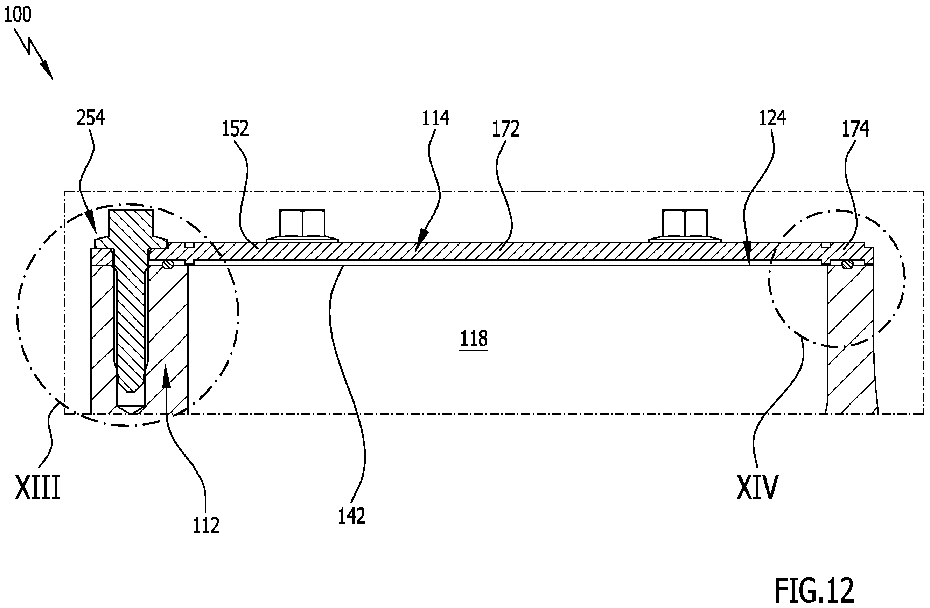

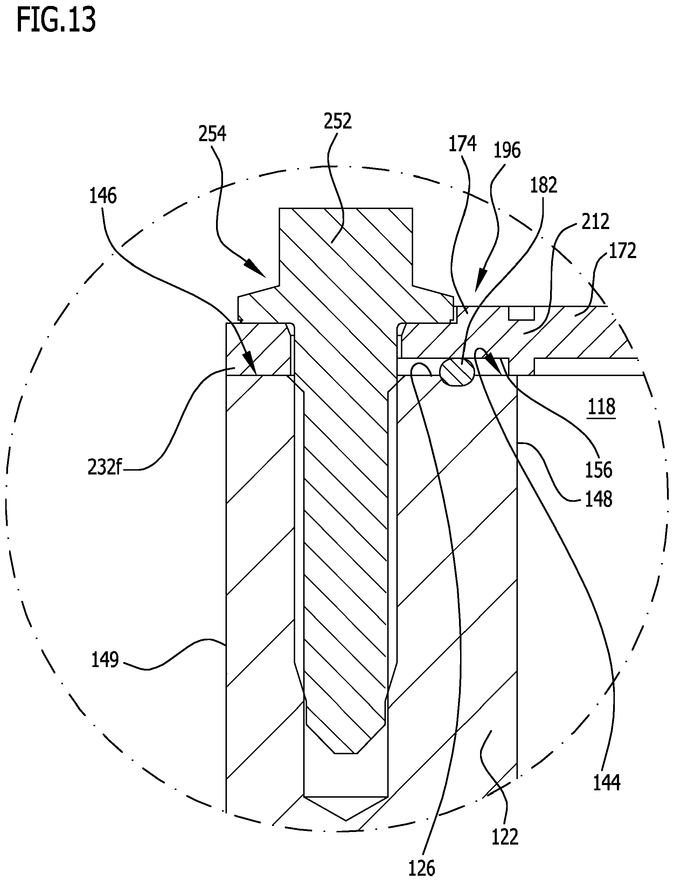

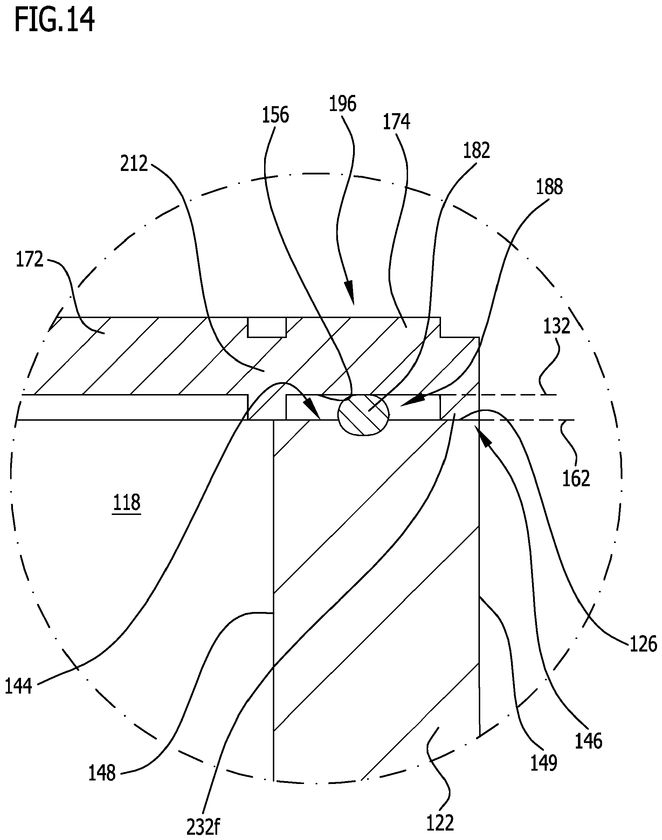

Ein beispielhaft in den Fig. 12 bis 15 dargestelltes siebtes Ausführungsbeispiel eines im Ganzen mit 100 bezeichneten Gehäuses umfasst zumindest zwei Gehäuseteile 112, 114, welche wiederum einen Innenraum 118 begrenzen.

Das erste Gehäuseteil 112 umfasst wiederum eine Umwandung 122, welche sich an einer Verbindungsseite 124 bis zu einer Verbindungsfläche 126 erstreckt. Insbesondere verläuft die Verbindungsfläche 126 zwischen einem dem Innenraum 118 zugewandten innenseitigen Randabschnitt 144 bis zu einem an einer gegenüberliegenden Seite, welche insbesondere eine Außenseite des Gehäuses ist, verlaufenden Randabschnitt 146. Insbesondere erstreckt sich die Verbindungsfläche 126 im Wesentlichen in einer geometrischen Verbindungsebene 132.

Von der Verbindungsfläche 126 erstreckt sich die Umwandung 122 hinweg und weist eine den Innenraum 118 begrenzende innenseitige Wandabschnittsfläche 148 auf und auf einer gegenüberliegenden Seite eine äußere Wandabschnittsfläche 149, welche beispielsweise in einem an der Verbindungsseite 124 angeordneten Verbindungsendbereich zueinander zumindest näherungsweise parallel verlaufen und sich zumindest näherungsweise senkrecht von der geometrischen Verbindungsebene 132 hinweg erstrecken.

An dem innenseitigen Randabschnitt 144 stößt die innenseitige Wandabschnittsfläche 148 an die Verbindungsfläche 126 und an dem äußeren Randabschnitt 146 stößt die äußere Wandabschnittsfläche 149 an die Verbindungsfläche 126, insbesondere kantenartige, an.

Die Verbindungsfläche 126 verläuft entlang einer Verbindungskontur 134 und begrenzt eine Gehäuseteilöffnung 142, welche innenraumseitig sich an den innenseitigen Randabschnitt 144 anschließt und insbesondere verläuft die Verbindungskontur 134 und damit die Verbindungsfläche 126 umfangseitig geschlossen um die Gehäuseteilöffnung 142 herum.

Beispielsweise ist das Gehäuseteil 112 ein Gussteil, insbesondere mit abgefräster Verbindungsfläche 126.

Das zweite Gehäuseteil 114 weist auch eine Umwandung 152 auf, welche zumindest teilweise den Innenraum 118 begrenzt und insbesondere in einem geschlossenen Zustand des Gehäuses die Gehäuseteilöffnung 142 deckelartig verschließt. Diese Umwandung 152 des Gehäuseteils 114 weist an einer Verbindungsseite 154 ebenso eine Verbindungsfläche 156 auf, welche entlang einer Verbindungskontur 164 verläuft, wobei die Verbindungskontur 164 korrespondierend zu der Verbindungskontur 134 des gegenüberliegend angeordneten Gehäuseteils 112 verläuft, so dass die beiden Verbindungsflächen 156, 126 dieser Gehäuseteile 114, 112 in dem geschlossenen Zustand des Gehäuses entlang eines Verbindungsabschnitts 196 einander zugewandt sind.

Mit einem Deckelabschnitt 172 begrenzt die Umwandung 152 in dem geschlossenen Zustand die Gehäuseteilöffnung 142 des gegenüberliegend angeordneten Gehäuseteils 112, wobei der Deckelabschnitt 172 insbesondere umfangseitig von dem Abschnitt 174 mit der Verbindungsfläche 156 umrandet wird.

Insbesondere ist dieses Gehäuseteil 114 im Wesentlichen als flaches Gehäuseteil 114 ausgebildet, welches sich im Wesentlichen parallel zu einer geometrischen Verbindungsebene 162, in welcher insbesondere die Verbindungsfläche 156 verläuft, erstreckt und eine Ausdehnung dieses flachen Gehäuseteils 114 senkrecht zu der geometrischen Verbindungsebene 162 ist wesentlich geringer als die Ausdehnung desselben parallel zur Geometrischen Verbindungsebene 162.

Vorzugsweise ist das insbesondere deckelartige Gehäuseteil 144 aus einem metallischen Werkstoff, insbesondere einem Blech, ausgebildet.

In dem geschlossenen Zustand des Gehäuses 100 ist zwischen den beiden Verbindungsflächen 126, 156 der Gehäuseteil 112, 114 ein Spalt 188, dessen Höhenausdehnung im Wesentlichen einem Abstand der beiden Verbindungsflächen 126, 156 entspricht.

Zur Abdichtung des Spalts 188 ist in diesem ein Dichtelement 182 vorgesehen, welches sich insbesondere entlang der Verbindungskonturen 134, 164 entlang des Verbindungsabschnitts 196 erstreckt und jeweils mit einer Seite abdichtend an den Verbindungsflächen 126 und 156 anliegt.

Beispielsweise liegt das Dichtelement 182 an flachen Abschnitten der Verbindungsflächen 126, 156 an. Bei Varianten ist an einer Verbindungsfläche 126, 156, insbesondere der Verbindungsfläche 126 des gegossenen Gehäuseteils 114, eine Nut, in welcher das Dichtelement 182 teilweise aufgenommen ist, vorgesehen.

Zum Schutz, insbesondere vor äußeren Einwirkungen, weist das insbesondere deckelartige Gehäuseteil 114 einen insbesondere randseitig umfangseitig verlaufenden als Abdeckungsabschnitt 232f ausgebildeten Schutzabschnitt auf.

Vorzugsweise sind an den Befestigungsstellen 254 um die Durchbrüche für die Befestigungsmittel 252 ebenfalls Abschnitte des Abdeckungsabschnitts 252f angeordnet, welche den jeweiligen Durchbruch zumindest außenseitig umranden und teilweise vollständig umranden. Insbesondere sind die Befestigungsstellen 254 an dem deckelartigen Gehäuseteil 114 als Flanschvorsprünge ausgebildet.

Dabei verläuft dieser Abdeckungsabschnitt 232f umfangseitig nicht geschlossen entlang der Verbindungskontur 164 sondern erstreckt sich nur abschnittsweise entlang dieser Kontur 164 entlang des Verbindungabschnitts 196. Zwischen den einzelnen Abschnitten des Abdeckungsabschnitts 232f sind Aussparungen 372 vorgesehen.

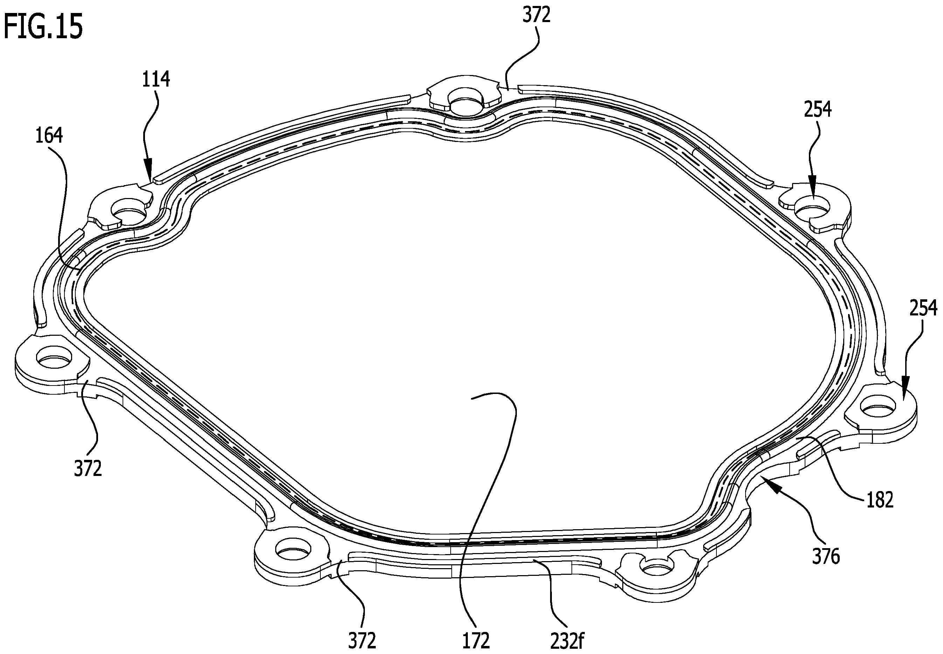

Insbesondere sind die Aussparungen im Bereich der Befestigungsstellen 254 vorgesehen, wie beispielsweise in der in Fig. 15 dargestellten Variante des Ausführungsbeispiels. Dabei sind die Aussparungen jeweils zwischen einem einen jeweiligen Durchbruch zumindest außenseitig umrandenden Abschnitt und einem zwischen zwei benachbarten Befestigungsstellen insbesondere durchgängig verlaufenden Abschnitt des Abdeckungsabschnitts 232f angeordnet. Vorzugsweise sind diese Aussparungen groß genug um beispielsweise Feuchtigkeit entweichen zu lassen und eine Kapillarwirkung zu vermeiden jedoch so klein wie möglich um eine Unterbrechung des Schutzes so gering wie möglich zu halten.

Beispielsweise ist in einem Angrenzungsbereich 376, in welchem außenseitig ein weiteres Bauteil an das Gehäuse angrenzt der äußere Abdeckungsabschnitt 232f ebenfalls unterbrochen mit einer Aussparung, da in diesem Bereich bereits durch das angrenzende Bauteil ein äußerer insbesondere mechanischer Schutz gegeben ist.

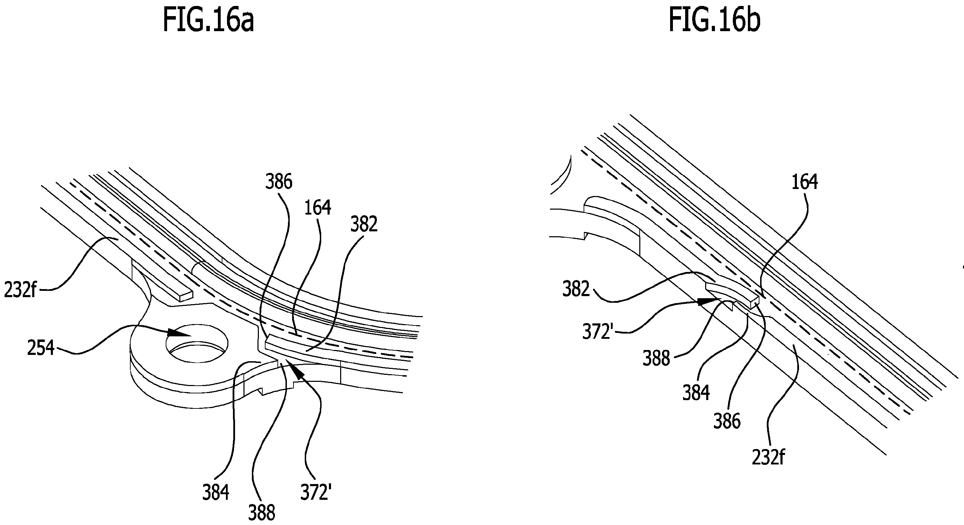

Bei Varianten des Ausführungsbeispiels, wie beispielhaft in Fig. 16a) und b) dargestellt ist, sind zumindest einige Aussparungen verwinkelt ausgebildet.

Dabei verlaufen zwei Teilabschnitte 382 und 384 des Schutzabschnitts 232f im Bereich der Aussparung 372' im Wesentlichen entlang der Verbindungskontur 164 jedoch quer zu dieser versetzt zueinander. Somit verläuft ein Freiraum der Aussparung 372' im Bereich des versetzten Verlaufs der beiden Teilabschnitte 382, 384 im Wesentlichen entlang der Verbindungskontur 164 und zwar im Wesentlichen von einem Ende 386 des einen Teilabschnitts 382 bis zu einem Ende 384 des anderen Teilabschnitts 388. An jedem der Enden 386 und 388 öffnet sich die Aussparung 372' zu je einer Querseite des Schutzabschnitts 232f, wobei hier eine Querseite dem Dichtelement 182 zugewandt ist und die andere Querseite nach außen gewandt ist. Somit weist der Schutzabschnitt 232f auch im Bereich der Aussparung 372' keinen zumindest näherungsweise senkrecht zu seiner Längserstreckung und zumindest näherungsweise senkrecht zur Verbindungskontur 164 verlaufenden freien Durchgang auf, so dass vorzugsweise auch in diesem Bereich das weiter innenseitig angeordnete Dichtelement vor äußeren Schadeinwirkungen, wie beispielsweise Flüssigkeitsstrahlen eines Hochdruckreinigers bei der Reinigung, geschützt ist.

Beispielsweise sind die verwinkelten Aussparungen 372' zwischen zwei Befestigungsstellen vorgesehen und vorzugsweise im Bereich einer Befestigungsstelle 254, so dass zumindest einer der Teilabschnitte, beispielsweise der Teilabschnitt 384, von einem einen Durchbruch zumindest teilweise umgebenden Abschnitt des Schutzabschnitts 232f ausgebildet wird.

Die Abschnitte des Abdeckungsabschnitts 232f liegen auf der Verbindungsfläche 126 des gegenüberliegend angeordneten Gehäuseteils 112 auf und zwar außenseitig, so dass das Dichtelement 182 zwischen dem Innenraum 118 und dem Abdeckungsabschnitt 232f angeordnet ist. Insbesondere liegen die Abschnitte des Abdeckungsabschnitts 232f auf dem äußeren Randabschnitt 146 auf und schließen bündig mit der Umwandung 122, insbesondere der äußeren Wandabschnittsfläche 149 des gegenüberliegend angeordneten Gehäuseteils 112 ab.

Bei diesem Ausführungsbeispiel ist der Abdeckungsabschnitt 232f als umgeformter Abschnitt des Gehäuseteils 114 ausgebildet, insbesondere sind die Abschnitte desselben eingeprägte Abschnitte.

Bei Varianten des Ausführungsbeispiels sind die Abschnitte des Abdeckungsabschnitts 232f alternativ oder ergänzend mit im Zusammenhang mit den Schutzabschnitten bei den anderen Ausführungsbeispielen erläuterten Merkmalen gebildet.

Bei einer weiteren Variante verläuft der Abdeckungsabschnitt 232f durchgängig entlang des Verbindungsabschnitts 196, beispielsweise umfangseitig geschlossen um die Gehäuseteilöffnung 142 herum.

Vorzugsweise ist auch bei diesem Gehäuse 100 ein als Kontaktierungsabschnitt 212 ausgebildeter Schutzabschnitt innenseitig vorgesehen, welcher insbesondere den innenseitigen Randabschnitt 144 kontaktiert. Bezüglich der Ausbildung dieses Kontaktierungsabschnitts wird auf die voranstehenden Ausführungen zu dem Ausführungsbeispiel mit dem eingeprägten Kontaktierungsabschnitt vollinhaltlich verwiesen. Bei Varianten des Ausführungsbeispiels ist der Kontaktierungsabschnitt 212 wie bei einem anderen der voranstehend beschriebenen Ausführungsbeispiele ausgebildet, so dass bezüglich dieser Varianten vollinhaltlich auf die voranstehenden Erläuterungen verwiesen wird.

Ferner sind Merkmale, welche im Zusammenhang mit diesem siebten Ausführungsbeispiel erläutert wurden, insbesondere bezüglich dem Gehäuse und dessen zumindest zwei Gehäuseteilen 112, 114 und/oder dem als Abdeckungsabschnitt 232f ausgebildeten Schutzabschnitt, welcher insbesondere bündig mit dem gegenüberliegend angeordneten Gehäuseteil abschließt, auch auf die anderen voranstehend erläuterten Ausführungsbeispiele übertragbar und/oder mit Merkmalen und Ausbildungen, welche im Zusammenhang mit diesen voranstehenden Ausführungsbeispielen erläutert wurden, kombinierbar.

Im Übrigen sind nicht näher erläuterte Merkmale und Elemente bei einem Ausführungsbeispiel vorzugsweise wie bei einem anderen der voranstehend erläuterten Ausführungsbeispiele ausgebildet, so dass vollinhaltlich auf die entsprechenden Ausführungen verwiesen wird.

## Patentansprüche

1. Gehäuse (100), insbesondere für eine elektrotechnische Vorrichtung, umfassend mindestens zwei Gehäuseteile (112, 114), welche jeweils eine Verbindungsfläche (126, 156) aufweisen, die in einem geschlossenen Zustand des Gehäuses (100) entlang eines Verbindungsabschnitts (196) einander zugewandt sind,
wobei entlang des Verbindungsabschnitts (196) zumindest eines der mindestens zwei Gehäuseteile (112, 114) zumindest einen integrierten Schutzabschnitt (212, 232), insbesondere für eine EMV-Abschirmung und/oder für einen mechanischen Schutz, aufweist,
**dadurch gekennzeichnet, dass** zumindest teilweise entlang des Verbindungsabschnitts (196) zumindest ein Schutzabschnitt (212, 232) einen Spalt (188) zwischen den mindestens zwei Gehäuseteilen (112, 114) außenseitig abdeckt.

2. Gehäuse (100) nach Anspruch 1, **dadurch gekennzeichnet, dass** entlang des Verbindungsabschnitts (196) genau ein Schutzabschnitt (212, 232) vorgesehen ist oder genau zwei Schutzabschnitte (212, 232) vorgesehen sind.

3. Gehäuse (100) nach einem der voranstehenden Ansprüche, **dadurch gekennzeichnet, dass** zumindest ein Schutzabschnitt (212, 232) verliersicher an einem der Gehäuseteile (112, 114) angeordnet ist.

4. Gehäuse (100) nach einem der voranstehenden Ansprüche, **dadurch gekennzeichnet**, durch zumindest eines der Folgenden:
- dass ein Abschnitt des einen Gehäuseteils (112, 114) zumindest einen Schutzabschnitt (212, 232) ausbildet;
und/oder
- dass zumindest ein Schutzabschnitt (212, 232) ein umgeformter Abschnitt des einen Gehäuseteils (112, 114) ist;
und/oder
- dass zumindest ein Schutzabschnitt (212, 232) in das eine Gehäuseteil (112, 114) eingepresst oder eingeprägt ist.

5. Gehäuse (100) nach einem der voranstehenden Ansprüche, **dadurch gekennzeichnet, dass** zumindest ein Schutzabschnitt (212, 232) ein an das eine Gehäuseteil (112, 114) angeformter Abschnitt ist.

6. Gehäuse (100) nach einem der voranstehenden Ansprüche, **dadurch gekennzeichnet, dass** zumindest ein Schutzabschnitt (212, 232) von einem einem Gehäuseteil (112, 114) zugeordneten Schutzelement (352) ausgebildet wird, wobei insbesondere das Schutzelement (352) mit einem Anordnungsabschnitt (354) mit dem einen Gehäuseteil (112, 114) verbunden ist,
wobei insbesondere zumindest eines der Folgenden vorgesehen ist:
- dass das Schutzelement (352) mittels Durchsetzfügen und/oder durch Stoffschluss, insbesondere Schweißen, mit dem einen Gehäuseteil (112, 114), verbunden ist;
und/oder
- dass das Schutzelement (352) aus einem metallischen Werkstoff ausgebildet ist, insbesondere eine metallische Lage ist;
und/oder
- dass zumindest ein Schutzabschnitt (212, 232) ein umgeformter Abschnitt des Schutzelements (352), insbesondere der metallischen Lage, ist.

7. Gehäuse (100) nach einem der voranstehenden Ansprüche,
**gekennzeichnet durch** zumindest eines der Folgenden:
- dass zumindest ein Schutzabschnitt (212, 232) flächig ausgebildet ist, insbesondere eine Kontaktierungsfläche (216) aufweist oder flächig zur Abdeckung eines Spalts zwischen den Verbindungsflächen (126, 156) in dem geschlossenen Zustand des Gehäuses (100) ausgebildet ist;
und/oder
- dass zumindest ein Schutzabschnitt (212, 232) eine Kante, insbesondere mit dornartigem Querschnitt, aufweist, welche insbesondere über eine Verbindungsseite (124, 154) des diesen Schutzabschnitt aufweisenden Gehäuseteils (112, 114) hervorsteht;
und/oder
- dass zumindest ein Schutzabschnitt (212, 232) durch eine Sicke, insbesondere in einem der Gehäuseteile (112, 114) und/oder in dem Schutzelement (352), ausgebildet wird;
und/oder
- dass zumindest ein Schutzabschnitt (212, 232) federnd gelagert ausgebildet ist;
und/oder
- dass zumindest ein Schutzabschnitt (212, 232) mit einem die Verbindungsfläche (126, 156) ausbildenden Abschnitt (174) und/oder mit dem Halteabschnitt (354) federnd verbunden ist.

8. Gehäuse (100) nach einem der voranstehenden Ansprüche,
**gekennzeichnet durch** zumindest eines der Folgenden:
- dass zumindest ein Schutzabschnitt (212, 232) in einem geschlossenen Zustand des Gehäuses (100) das gegenüberliegend angeordnete der mindestens zwei Gehäuseteile (112, 114) entlang des Verbindungsabschnitts (196) zumindest teilweise, insbesondere zumindest näherungsweise durchgängig kontaktiert;
und/oder
- dass zumindest ein Schutzabschnitt (212, 232) in dem geschlossenen Zustand des Gehäuses (100) an der Verbindungsfläche (126, 156) des gegenüberliegend angeordneten Gehäuseteils (112, 114) zumindest teilweise anliegt;
und/oder
- dass zumindest ein Schutzabschnitt (212, 232) in dem geschlossenen Zustand des Gehäuses (100) zumindest teilweise an einer von der Verbindungsfläche (126, 156) sich hinweg erstreckenden Wandabschnittsfläche (148, 149) des gegenüberliegend angeordneten Gehäuseteils (112, 114) anliegt;
und/oder
- dass zumindest ein Schutzabschnitt (212, 232) entlang des Verbindungsabschnitts (196) zumindest teilweise, insbesondere durchgängig, von dem gegenüberliegend angeordneten Gehäuseteil (112, 114), insbesondere von einer äußeren Wandabschnittsfläche (149) desselben, beabstandet ist.

9. Gehäuse (100) nach einem der voranstehenden Ansprüche,
**gekennzeichnet durch** zumindest eines der Folgenden:
- dass zumindest ein Schutzabschnitt (212, 232) entlang des Verbindungsabschnitts (196) eine oder mehrere Aussparungen (372) aufweist, wobei insbesondere im Bereich zumindest einer Aussparung (372) der zumindest eine Schutzabschnitt zwei Teilabschnitte aufweist, welche quer zu der Verbindungskontur versetzt zueinander verlaufen und die Aussparung im Bereich des versetzten Verlaufs zwischen den zwei Teilabschnitten verläuft;
und/oder
- dass zumindest ein Schutzabschnitt (212, 232) innenseitig entlang des Verbindungsabschnitts (196) angeordnet ist, insbesondere an einem innenseitigen Randabschnitt (144) einer Umwandung (122, 152) des Gehäuses (100) angeordnet ist;
und/oder
- dass zumindest ein Schutzabschnitt (212, 232) außenseitig entlang des Verbindungsabschnitts (196) angeordnet ist, insbesondere an einem außenseitigen Randabschnitt (146) und/oder einer außenseitigen Wandabschnittsfläche (149) einer Umwandung (122, 152) des Gehäuses (100).

10. Gehäuse (100) nach einem der voranstehenden Ansprüche, **dadurch gekennzeichnet, dass** die zumindest zwei Gehäuseteile (112, 114) außenseitig bündig abschließen, insbesondere zumindest ein Schutzabschnitt (212, 232) bündig mit dem gegenüberliegenden Gehäuseteil abschließt.

11. Gehäuse (100) nach einem der voranstehenden Ansprüche, **dadurch gekennzeichnet,**
- **dass** zumindest entlang des Verbindungsabschnitts (196) zumindest ein Schutzabschnitt (212, 232) beaufschlagt an dem gegenüberliegend angeordneten Gehäuseteil (112, 114) anliegt;
und/oder
- **dass** zumindest entlang des Verbindungsabschnitts (196) zumindest ein Schutzabschnitt (212, 232) zumindest teilweise sich plastisch verformend an das gegenüberliegend angeordnete Gehäuseteil (112, 114) anpasst.

12. Gehäuse (100) nach einem der voranstehenden Ansprüche, **dadurch gekennzeichnet, dass** zumindest in dem geschlossenen Zustand zwischen den beiden Verbindungsflächen (126, 156) der zumindest zwei Gehäuseteile (112, 114) ein Dichtelement (182), insbesondere als Dichtraupe, angeordnet ist;
wobei insbesondere zumindest eines der Folgenden vorgesehen ist:
- dass das Dichtelement (182) an einem der Gehäuseteile (112, 114) fest angeordnet ist;
und/oder
- dass relativ zu dem Dichtelement (182) innenseitig und/oder außenseitig zumindest ein Schutzabschnitt (212, 232) angeordnet ist;
und/oder
- dass ein Halteabschnitt (354) und das Dichtelement (182) zusammen an einem der Gehäuseteile (112, 114) angeordnet sind, insbesondere der Halteabschnitt (354) zwischen dem einen Gehäuseteil (112, 114) und dem Dichtelement (182) gehalten ist.

13. Gehäuse (100) nach einem der voranstehenden Ansprüche, **dadurch gekennzeichnet, dass** die mindestens zwei Gehäuseteile (112, 114), insbesondere axial, aneinander gepresst sind.

14. Elektrotechnische Vorrichtung, **dadurch gekennzeichnet, dass** diese ein Gehäuse (100) nach einem der voranstehenden Ansprüche umfasst, wobei insbesondere zumindest ein elektrisches Bauteil der elektrotechnischen Vorrichtung in dem Innenraum (118) des Gehäuses angeordnet ist.

15. Kraftfahrzeugbauteil und/oder Kraftfahrzeug **gekennzeichnet durch** ein Gehäuse (100) und/oder eine elektrotechnische Vorrichtung nach einem der voranstehenden Ansprüche.

## Claims

1. Housing (100), in particular for an electrotechnical device, comprising at least two housing parts (112, 114) which each have a connecting surface (126, 156) which, in a closed state of the housing (100), face each other along a connecting portion (196),
at least one of the at least two housing parts (112, 114) having, along the connecting portion (196), at least one integrated protective portion (212, 232), in particular for EMC shielding and/or for mechanical protection,
**characterized in that,** at least partially along the connecting portion (196), at least one protective portion (212, 232) externally covers a gap (188) between the at least two housing parts (112, 114).

2. Housing (100) according to claim 1, **characterized in that**, along the connecting portion, exactly one protective portion (212, 232) is provided (196) or exactly two protective portions (212, 232) are provided.

3. Housing (100) according to any of the preceding claims,
**characterized in that** at least one protective portion (212, 232) is arranged captively on one of the housing parts (112, 114).

4. Housing (100) according to any of the preceding claims, **characterized by** at least one of the following:
- **in that** a portion of the one housing part (112, 114) forms at least one protective portion (212, 232);
and/or
- **in that** at least one protective portion (212, 232) is a deformed portion of the one housing part (112, 114);
and/or
- **in that** at least one protective portion (212, 232) is pressed or stamped into the one housing part (112, 114).

5. Housing (100) according to any of the preceding claims,
**characterized in that** at least one protective portion (212, 232) is a portion formed on the one housing part (112, 114).

6. Housing (100) according to any of the preceding claims,
**characterized in that** at least one protective portion (212, 232) is formed by a protective element (352) assigned to a housing part (112, 114), in particular the protective element (352) being connected to the one housing part (112, 114) by means of an arrangement portion (354),
in particular at least one of the following being provided:
- that the protective element (352) is connected to the one housing part (112, 114) by means of clinching and/or by material bonding, in particular welding;
and/or
- that the protective element (352) is made of a metal material, in particular is a metal layer;
and/or
- that at least one protective portion (212, 232) is a deformed portion of the protective element (352), in particular of the metal layer.

7. Housing (100) according to any of the preceding claims, **characterized by** at least one of the following:
- that at least one protective portion (212, 232) is planar, in particular has a contacting surface (216) or is planar in order to cover a gap between the connecting surfaces (126, 156) in the closed state of the housing (100);
and/or
- that at least one protective portion (212, 232) has an edge, in particular having a thorn-like cross section, which protrudes in particular over a connecting side (124, 154) of the housing part (112, 114) having said protective portion;
and/or
- that at least one protective portion (212, 232) is formed by a bead, in particular in one of the housing parts (112, 114) and/or in the protective element (352);
and/or
- that at least one protective portion (212, 232) is resiliently mounted;
and/or
- that at least one protective portion (212, 232) is resiliently connected to a portion (174) forming the connecting surface (126, 156) and/or to the holding portion (354).

8. Housing (100) according to any of the preceding claims, **characterized by** at least one of the following:
- that at least one protective portion (212, 232) contacts the oppositely arranged housing part of the at least two housing parts (112, 114) at least partially, in particular at least approximately continuously, along the connecting portion (196) in a closed state of the housing (100);
and/or
- that at least one protective portion (212, 232) at least partially rests on the connecting surface (126, 156) of the oppositely arranged housing part (112, 114) in the closed state of the housing (100);
and/or
- that at least one protective portion (212, 232) at least partially rests on a wall portion surface (148, 149) of the oppositely arranged housing part (112, 114) that extends away from the connecting surface (126, 156) in the closed state of the housing (100);
and/or
- that at least one protective portion (212, 232), along the connecting portion (196), is at least partially, in particular continuously, spaced from the oppositely arranged housing part (112, 114), in particular from an outer wall portion surface (149) thereof.

9. Housing (100) according to any of the preceding claims, **characterized by** at least one of the following:
- that at least one protective portion (212, 232) has one or more recesses (372) along the connecting portion (196), the at least one protective portion having two partial portions, in particular in the region of at least one recess (372), which partial portions extend offset from one another transversely to the connecting contour, and the recess extending in the region of the offset course between the two partial portions;
and/or
- that at least one protective portion (212, 232) is arranged on the inside along the connecting portion (196), in particular on an inner edge portion (144) of a wall (122, 152) of the housing (100);
and/or
- that at least one protective portion (212, 232) is arranged on the outside along the connecting portion (196), in particular on an outside edge portion (146) and/or an outside wall portion surface (149) of a surrounding wall (122, 152) of the housing (100).

10. Housing (100) according to any of the preceding claims,
**characterized in that** the at least two housing parts (112, 114) are flush on the outside, in particular at least one protective portion (212, 232) is flush with the opposite housing part.

11. Housing (100) according to any of the preceding claims,
**characterized in that**
- at least along the connecting portion (196), at least one protective portion (212, 232) bears against the oppositely arranged housing part (112, 114);
and/or
- **in that**, at least along the connecting portion (196), at least one protective portion (212, 232) at least partially adapts to the oppositely arranged housing part (112, 114) by plastic deformation.

12. Housing (100) according to any of the preceding claims,
**characterized in that**, at least in the closed state, a sealing element (182) is arranged between the two connecting surfaces (126, 156) of the at least two housing parts (112, 114), in particular as a sealing bead;
in particular at least one of the following being provided:
- that the sealing element (182) is fixedly arranged on one of the housing parts (112, 114);
and/or
- that at least one protective portion (212, 232) is arranged on the inside and/or outside relative to the sealing element (182);
and/or
- that a holding portion (354) and the sealing element (182) are arranged together on one of the housing parts (112, 114), in particular that the holding portion (354) is held between the one housing part (112, 114) and the sealing element (182).

13. Housing (100) according to any of the preceding claims,
**characterized in that** the at least two housing parts (112, 114) are pressed against one another, in particular axially.

14. Electrotechnical device, **characterized in that** it comprises a housing (100) according to any of the preceding claims, in particular at least one electrical component of the electrotechnical device being arranged in the interior (118) of the housing.

15. Motor vehicle component and/or motor vehicle **characterized by** a housing (100) and/or an electrotechnical device according to any of the preceding claims.

## Revendications

1. Boîtier (100), en particulier pour un dispositif électrotechnique, comprenant au moins deux parties de boîtier (112, 114) qui présentent respectivement une surface de liaison (126, 156) qui, dans un état fermé du boîtier (100), sont tournées l'une vers l'autre le long d'une section de liaison (196),
dans lequel, le long de la section de liaison (196), au moins l'une parmi les au moins deux parties de boîtier (112, 114) présente au moins une section de protection (212, 232) intégrée, en particulier pour un blindage CEM et/ou pour une protection mécanique,
**caractérisé en ce que**, au moins partiellement le long de la section de liaison (196), au moins une section de protection (212, 232) recouvre côté extérieur un interstice (188) entre les au moins deux parties de boîtier (112, 114).

2. Boîtier (100) selon la revendication 1, **caractérisé en ce qu'**exactement une section de protection (212, 232) est prévue le long de la section de liaison (196) ou exactement deux sections de protection (212, 232) sont prévues.

3. Boîtier (100) selon l'une des revendications précédentes,
**caractérisé en ce qu'**au moins une section de protection (212, 232) est disposée de manière imperdable sur l'une des parties de boîtier (112, 114).

4. Boîtier (100) selon l'une des revendications précédentes, **caractérisé par** au moins l'un parmi les suivants :
- **en ce qu'**une section d'une partie de boîtier (112, 114) forme au moins une section de protection (212, 232) ;
et/ou
- **en ce qu'**au moins une section de protection (212, 232) est une section déformée d'une partie de boîtier (112, 114) ;
et/ou
- **en ce qu'**au moins une section de protection (212, 232) est pressée ou estampée dans une partie de boîtier (112, 114).

5. Boîtier (100) selon l'une des revendications précédentes,
**caractérisé en ce qu'**au moins une section de protection (212, 232) est une section formée sur une partie de boîtier (112, 114).

6. Boîtier (100) selon l'une des revendications précédentes,
**caractérisé en ce qu'**au moins une section de protection (212, 232) est formée par un élément de protection (352) associé à une partie de boîtier (112, 114), dans lequel en particulier l'élément de protection (352) est relié à une partie de boîtier (112, 114) par une section de disposition (354),
dans lequel en particulier au moins l'un parmi les suivants est prévu :
- **en ce que** l'élément de protection (352) est relié à une partie de boîtier (112, 114) au moyen d'un clinchage et/ou par liaison de matière, en particulier par soudage ;
et/ou
- **en ce que** l'élément de protection (352) est formé à partir d'un matériau métallique, en particulier est une couche métallique ;
et/ou
- **en ce qu'**au moins une section de protection (212, 232) est une section déformée de l'élément de protection (352), en particulier de la couche métallique.

7. Boîtier (100) selon l'une des revendications précédentes, **caractérisé par** au moins l'un parmi les suivants :
- **en ce qu'**au moins une section de protection (212, 232) est formée à plat, en particulier présente une surface de contact (216) ou est formée à plat pour recouvrir un interstice entre les surfaces de liaison (126, 156) dans l'état fermé du boîtier (100) ;
et/ou
- **en ce qu'**au moins une section de protection (212, 232) présente un bord, en particulier comportant une section transversale en forme d'épine, lequel bord fait en particulier saillie au-dessus d'un côté de liaison (124, 154) de la partie de boîtier (112, 114) présentant ladite section de protection ;
et/ou
- **en ce qu'**au moins une section de protection (212, 232) est formée par une moulure, en particulier dans l'une des parties de boîtier (112, 114) et/ou dans l'élément de protection (352) ;
et/ou
- **en ce qu'**au moins une section de protection (212, 232) est formée de manière à être montée sur un ressort ;
et/ou
- **en ce qu'**au moins une section de protection (212, 232) est reliée au moyen d'un ressort à une section (174) formant la surface de liaison (126, 156) et/ou à la section de maintien (354).

8. Boîtier (100) selon l'une des revendications précédentes, **caractérisé par** au moins l'un parmi les suivants :
- **en ce qu'**au moins une section de protection (212, 232), dans un état fermé du boîtier (100), entre en contact au moins partiellement, en particulier au moins approximativement de manière continue, avec la partie de boîtier disposée à l'opposé parmi les au moins deux parties de boîtier (112, 114) le long de la section de liaison (196) ;
et/ou
- **en ce qu'**au moins une section de protection (212, 232), dans l'état fermé du boîtier (100), repose au moins partiellement sur la surface de liaison (126, 156) de la partie de boîtier (112, 114) disposée à l'opposé ;
et/ou
- **en ce qu'**au moins une section de protection (212, 232), dans l'état fermé du boîtier (100), repose au moins partiellement sur une surface de section de paroi (148, 149) de la partie de boîtier (112, 114) disposée à l'opposé, laquelle surface de section de paroi s'étend depuis la surface de liaison (126, 156) ;
et/ou
- **en ce qu'**au moins une section de protection (212, 232), le long de la section de liaison (196), est espacée au moins partiellement, en particulier de manière continue, de la partie de boîtier (112, 114) disposée à l'opposé, en particulier d'une surface de section de paroi extérieure (149) de celle-ci.

9. Boîtier (100) selon l'une des revendications précédentes, **caractérisé par** au moins l'un parmi les suivants :
- **en ce qu'**au moins une section de protection (212, 232), le long de la section de liaison (196), présente un ou plusieurs évidements (372), dans lequel, en particulier dans la zone d'au moins un évidement (372), l'au moins une section de protection présente deux sections partielles qui s'étendent de manière décalée l'une par rapport à l'autre transversalement au contour de liaison et l'évidement s'étend entre les deux sections partielles dans la zone de l'extension décalée ;
et/ou
- **en ce qu'**au moins une section de protection (212, 232) est disposée côté intérieur le long de la section de liaison (196), en particulier est disposée sur une section de rebord intérieure (144) d'une paroi enveloppante (122, 152) du boîtier (100) ;
et/ou
- **en ce qu'**au moins une section de protection (212, 232) est disposée côté extérieur le long de la section de liaison (196), en particulier sur une section de rebord extérieure (146) et/ou une surface de section de paroi extérieure (149) d'une paroi enveloppante (122, 152) du boîtier (100).

10. Boîtier (100) selon l'une des revendications précédentes,
**caractérisé en ce que** les au moins deux parties de boîtier (112, 114) se terminent à fleur du côté extérieur, en particulier au moins une section de protection (212, 232) se termine à fleur de la partie de boîtier opposée.

11. Boîtier (100) selon l'une des revendications précédentes, **caractérisé en ce**
- **que**, au moins le long de la section de liaison (196), au moins une section de protection (212, 232) repose, en étant sollicitée, sur la partie de boîtier (112, 114) disposée à l'opposé ;
et/ou
- **que**, au moins le long de la section de liaison (196), au moins une section de protection (212, 232) s'adapte au moins partiellement à la partie de boîtier (112, 114) disposée à l'opposé en se déformant plastiquement.

12. Boîtier (100) selon l'une des revendications précédentes,
**caractérisé en ce que**, au moins dans l'état fermé, un élément d'étanchéité (182), en particulier sous forme de cordon d'étanchéité, est disposé entre les deux surfaces de liaison (126, 156) des au moins deux parties de boîtier (112, 114) ;
dans lequel en particulier au moins l'un parmi les suivants est prévu :
- **en ce que** l'élément d'étanchéité (182) est disposé de manière fixe sur l'une des parties de boîtier (112, 114) ;
et/ou
- **en ce que**, par rapport à l'élément d'étanchéité (182), au moins une section de protection (212, 232) est disposée côté intérieur et/ou côté extérieur ;
et/ou
- **en ce qu'**une section de maintien (354) et l'élément d'étanchéité (182) sont disposés conjointement sur l'une des parties de boîtier (112, 114), en particulier la section de maintien (354) est maintenue entre une partie de boîtier (112, 114) et l'élément d'étanchéité (182).

13. Boîtier (100) selon l'une des revendications précédentes,
**caractérisé en ce que** les au moins deux parties de boîtier (112, 114) sont pressées l'une contre l'autre, en particulier axialement.

14. Dispositif électrotechnique, **caractérisé en ce que** ledit dispositif électrotechnique comprend un boîtier (100) selon l'une des revendications précédentes, dans lequel en particulier au moins un composant électrique du dispositif électrotechnique est disposé dans l'espace intérieur (118) du boîtier.

15. Composant de véhicule automobile et/ou véhicule automobile
**caractérisé par** un boîtier (100) et/ou un dispositif électrotechnique selon l'une des revendications précédentes.
